# EUROPEAN PATENT SPECIFICATION

(11) **EP 4 575 425 B1**
(45) Date of publication and mention of the grant of the patent: **15.07.2026**
(21) Application number: 24221074.8
(22) Date of filing: 18.12.2024
(51) Int. Cl.: G01H 1/00

(54) **CONDITION MONITORING SENSOR AND SENSOR BOARD FASTENING**
ZUSTANDSÜBERWACHUNGSSENSOR UND SENSORPLATTENBEFESTIGUNG
CAPTEUR DE SURVEILLANCE D'ÉTAT ET FIXATION DE CARTE DE CAPTEUR

(30) Priority: 19.12.2023 DK PA202330408
(43) Date of publication of application: 25.06.2025
(73) Proprietor: CeramicSpeed Digital A/S, 7500 Holstebro (DK)
(72) Inventor: HERSKIND, Eskild Sune, 2670 Greve (DK)
(74) Representative: Patentgruppen A/S

(56) References cited:
- EP-A2- 1 890 119
- DE-A1- 19 829 410
- US-A- 5 130 600
- US-A1- 2008 024 158
- US-A1- 2014 096 611

## Description

### Field of the invention

The present invention relates to condition monitoring sensors, such as vibration sensors, having a sensor board, and to fastening and removal of sensor boards in condition monitoring sensors.

### Background of the invention

Vibration sensors for monitoring vibration in mechanical systems, for example for ensuring compliance with regulations or for detecting mounting or component defects, typically have a vibration transducer that transforms mechanical vibration into electrical signals, and electronics for controlling, processing and transmitting the electrical signal.

Some vibration transducers, typically in older vibration sensors, are enclosed in or consists of solid metal parts that can be firmly mounted onto the system under inspection for good transfer of vibrations to the vibration transducer.

Other, typically newer, smaller, less expensive, vibration sensing elements are packaged for soldering onto a printed circuit board PCB. A vibration sensor housing holds the PCB with the vibration sensing element, and is designed, for example with a solid metal base, for firm connection with a system under inspection.

In such vibration sensors, however, the vibrations transferred to the base also need to be transferred further to the PCB and the vibration sensing element mounted thereon. For this purpose, the PCB may typically be secured to the base by screws. Using only a few screws makes assembly quick and inexpensive, but does not ensure that the connection between the base and the relatively flexible PCB is sufficiently mechanically stiff. An insufficiently mechanically stiff interface between base and PCB can impede the transfer of vibrations to the vibration sensing element possibly causing signal attenuation and/or reduction in usable bandwidth. EP1890119A2 attempts to improve such solutions by placing the sensor right next to the fastening screw and by fastening the sensor between the base and the PCB.

A widely used alternative to screws is to fix the PCB in the vibration sensor's enclosure using a method called potting. Potting typically involves using some form of epoxy to encase the PCB and fill up the enclosure such that the epoxy provides a medium for vibrations to pass through, wherein the PCB is fixed without the possibility of flexing. Potting is a relatively complex process and requires that the filler material such as epoxy is allowed to cure for some time before the vibration sensor is used. Once potting has been completed, it becomes difficult to gain access to the vibration sensor's components such as for disassembly, repair, or recycling.

### Summary of the invention

The inventor has identified the above-mentioned problems and challenges related to vibration transfer in condition monitoring sensors such as vibration sensors, and subsequently made the below-described invention which may improve by quality, speed and/or cost one or more of assembling/disassembling and vibration transfer.

The invention relates to a condition monitoring sensor comprising a vibration sensing element mounted on a sensor board comprising a first sensor board surface and a second sensor board surface; a base comprising a sensor board support structure having a sensor board receiving surface conforming to a first clamping region of said first sensor board surface; a clamping arrangement comprising a clamping head and a clamping body; said clamping head having a sensor board clamping surface conforming to a second clamping region of said second sensor board surface and a body receiving surface, and said clamping body having a head receiving surface; said clamping arrangement being arranged to establish a clamping direction to clamp said sensor board between said clamping head and said sensor board support structure of said base by means of said clamping head and said clamping body; and wherein said head receiving surface is slidably in contact with said body receiving surface; and wherein said clamping arrangement is arranged to establish said clamping direction when said clamping body or said clamping head is moved relative to said base along a displacement direction different from said clamping direction and said head receiving surface and said body receiving surface slide on each other.

According to the present invention, a stable and efficient mechanical connection may be achieved between the base of the condition monitoring sensor, such as a vibration sensor, and a sensor board holding the vibration sensing element thereof.

According to the present invention, a simple and fast assembling of a condition monitoring sensor may be achieved, optionally also allowing easy disassembling for repair or recycling.

According to the present invention, a fast assembling of the condition monitoring sensor is facilitated by fastening in a direction not parallel to the sensor board. The components of the condition monitoring sensor may e.g. be placed in the base and subsequently the fastening means may be provided. This simplifies the assembly since no holes or openings in the side of the base are necessary, through which a fastener may be provided.

A condition monitoring sensor according to the invention may thus be efficient in use and/or in assembling, and thereby be advantageous for use in monitoring of mechanical systems where reliability and high uptime is important for safety and/or productivity. The efficiency in use, such as high usability and accuracy, may ensure reliability and allow for detection of a wide range of errors or instabilities. The efficiency in assembling may allow for cost reduction and repairing, thereby making it feasible to apply condition monitoring sensors, such as vibration sensors, permanently at more monitoring sites, such as more motors, bearings, transmissions and other industrial assets, to achieve a high degree of vibration monitoring in a crucial production.

The invention may in various embodiments by means of the clamping allow for improved and/or less attenuated transfer of vibrations from a system to be monitored, such as a motor or bearing, to the vibration sensing element.

A condition monitoring sensor with improved transfer of vibrations to the vibration sensing element may typically be useful in a broader frequency band, have higher signal-to-noise ratio, be more robust against resonance, or a combination thereof, compared to prior art vibration sensors having sensor-board mounted vibration elements.

Improved and/or less attenuated transfer may for example refer to a resulting transfer function for vibrations, which in the frequency band relevant for monitoring is having less attenuation in the pass band, having a higher upper cutoff frequency, having less resonance peaks, having reduced resonance peaks, having resonances moved to higher frequencies, having improved signal-to-noise ratio, or combinations of the mentioned improvements.

The desired or relevant bandwidth and other properties of the vibration sensing part of a condition monitoring sensor depends on the application and especially which types of fault modes should be detected. For instance, the inventor has found that for detecting or monitoring fault modes typically associated with rotating equipment such as one or more of rotational imbalance, bent shaft or shaft misalignment, cocked bearing, eccentric pulley, rotating looseness, structural looseness, non-rotating looseness, or electrical faults, it may typically be sufficient to measure vibrations at frequencies up to approximately 1 or 2 kHz. An example of this application is monitoring an unstable fan, or detecting that a machine has been incorrectly mounted such that it during operation moves in a vibrating motion which may cause a continuously reciprocating, circular or oval displacement of the machine in space by e.g. 10 micrometers or up to 0.1 millimeters. Machine displacement is often represented by a value which indicates how many millimeters the machine has been displaced per second. When detecting these types of machine errors, it becomes important that magnitude distortion or resonances are not introduced to the vibration signals by the condition monitoring sensor. Magnitude distortion or resonances within the relevant bandwidth reduces the likelihood of detecting such types of errors by masking the error-indicating velocity of the signal, because these types of errors are typically classified by table look-up or threshold values which categorize errors based on the amount of velocity in millimeters per second. By means of the present invention, the sensor board clamping configuration may achieve that resonances are moved up above at least 1 kHz and/or that the resonance amplitude at the sensor position is reduced. The clamping configuration of the present invention achieves this among others by ensuring a mechanically stiff connection between the sensor board and the support structure and reducing the risk of rattling between the sensor board and its support.

Further, the inventor has found that for other types of fault modes, such as those related to bearings and lubrication, require a vibration sensor that can measure in a frequency band between for example 5 kHz and 10 kHz, where analyzing the modulation of frequencies is especially important for detecting bearing errors, and resonances within the bandwidth may be acceptable. By means of the present invention, the sensor board clamping configuration may achieve that vibration even in higher frequencies such as from 5 kHz to 10 kHz are transferred sufficiently through the base and sensor board to the vibration sensing element. The clamping configuration of the present invention achieves this among others by establishing a mechanically stiff and firm connection between base and sensor board.

The invention may in various embodiments by means of the displacement of the clamping body along a displacement direction different from the clamping direction, achieve that by even a single or a few fasteners, such as a single screw, a clamping force is established which is distributed substantially evenly over the clamping regions of the sensor board, such as preferably at several locations near the vibration sensing element, to achieve a stable mechanical connection and transfer of vibrations to the vibration sensing elements. Embodiments of the invention that thereby avoid numerous screws around the vibration sensing element otherwise required for achieving a stable mechanical connection makes the assembly faster and easier and may even achieve improved mechanical connection by a smoothly distributed clamping force. Embodiments of the invention that thereby avoid filling with epoxy or other filler material to fixate the vibration sensing element makes the assembly much faster and easier, and allows for subsequent disassembling, repairing and recycling.

The inventor has confirmed through a computer simulation, that proposed embodiments of the invention may provide advantages derived from the substantially more mechanically stiff connection between the sensor board and the base of the condition monitoring sensor as compared to the prior art. A simulation program was used to create a computer model of an embodiment of a condition monitoring sensor with a clamping arrangement as disclosed in this invention. A computer model of a conventional condition monitoring sensor where the sensor board is attached using four screws was also created. A test scenario was formulated whereby both condition monitoring sensor models were subjected to continuous vibrations at their base, equivalent to a displacement of 0.1 millimeters over a frequency range from 1 Hz to 25 kHz. The additional displacement seen at the vibration sensing element was estimated for both condition monitoring sensor computer models. The simulated experiment indicated that, for a conventional condition monitoring sensor with screw-attached sensor board, the maximum displacement of the vibration sensing element in the frequency band from 1 Hz to 25 kHz was 2.8 millimeters. The condition monitoring sensor with a clamping arrangement according to an embodiment of the invention experienced a maximum additional displacement of the vibration sensing element of 8 micrometers in the frequency band from 1 Hz to 25 kHz. Maximum displacement at the vibration sensing element of the condition monitoring sensor with screw-attached sensor board was thus found to be more than two orders of magnitude greater than the maximum displacement at the vibration sensing element of the condition monitoring sensor with a clamping arrangement according to an embodiment of the invention. The results of the inventor's simulation indicate that a substantially more stiff mechanical connection between the sensor board and the base can be achieved when using a clamping arrangement as disclosed by the invention, at least when compared to condition monitoring sensors with screw-attached sensor boards.

A condition monitoring sensor is understood as a unit arranged to measure one or more parameters relating to a mechanical system. The condition monitoring sensor according to the present invention involves one or more vibration sensing elements so as to measure parameters relating to vibration or acceleration, whereby the condition monitoring sensor may also be referred to as a vibration sensor. It may in various embodiments comprise further types of sensors to monitor parameters like temperature, humidity, pressure, noise, etc., as known from the field of condition monitoring. The condition monitoring sensor may be a separate unit arranged to be in mechanical contact with the system to be monitored, preferably by a firm mounting, or it may be built-in to the system to be monitored. The condition monitoring sensor may also be a handheld unit which is brought into contact with the system to be monitored via a probe which is held against a relevant part for vibration measurements. Preferably, the condition monitoring sensor is in communicative connection with some kind of local or remote backend system like a server or smartphone to process the measurements. The condition monitoring sensor may also comprise a display or other information or warning means to convey results of the monitoring or measured data locally.

A vibration sensing element is understood as any transducer or sensor that is sensitive to acceleration or vibration and can be mounted on a sensor board. The vibration sensing element may for example be a one- or three-axis accelerometer based on any accelerometer technology suitable for the intended use case and is packaged in a way suitable for soldering or otherwise mounting on the sensor board. The vibration sensing element may for example be a MEMS accelerometer. Vibration sensing elements and various options and considerations in this regard are elaborated further below.

A sensor board according to the invention may be any suitable support structure for the vibration sensing element and related electrical connections, such as for example a printed circuit board PCB or a board created using additive manufacturing, such as 3D printing technologies. The sensor board may preferably support further sensors and other electronics. The sensor board may typically be comprised primarily of a relatively flat piece of dielectric material, with circuit traces embedded on one or both sides or between dielectric layers, and having the vibration sensing element and possibly other electronics mounted by for example soldering or gluing on one or both of the flat sides, herein referred to as the first and second sensor board surfaces. Components such as vibration sensing elements, other sensors, and other electronics, thus typically protrude from at least one of the sensor board surfaces, typically leaving regions without protrusions between and around them. Electrical connections may be established by separate wiring protruding somewhat from the sensor board, or, preferably, by circuit traces integrated on or in the sensor board, forming no, or at least only insignificant, protrusion.

First and second clamping regions of the first and second sensor board surfaces, respectively, are understood as regions of the sensor board surfaces which allow for clamping the sensor board, because these regions are free from protrusions or vibration sensing elements or other components or wiring. In other words, the clamping regions of the sensor board may refer to all the locations on the sensor board where it can be safely clamped without damaging sensors and other electronics. The base and clamping arrangement between which the sensor board is clamped are configured so that they only apply clamping force at locations that are part of the clamping regions.

A base of the condition monitoring sensor is understood as a part where other parts, at least the sensor board, are mounted. Preferably the base is of a light and mechanically stiff material although a tradeoff between lightness and stiffness may be determined. The base may be composed of a material such as metal, e.g. steel, copper, brass, aluminum, etc., or a suitable composite material or polymer, in order to provide good transfer of vibration to the sensor board and thereby the vibration sensing element. For the same reason, the base preferably also comprises or is in strong mechanical connection with the connector, herein referred to as vibration interface, by which the condition monitoring sensor is mounted on or otherwise interfaces the system to be monitored.

A sensor board support structure according to the invention is a part of the base where the sensor board is mounted. It may be monolithically integrated with the base or be mechanically firmly connected therewith, any of which are herein considered as being part of the base. A sensor board receiving surface of the sensor board support structure is arranged to receive the first sensor board surface, and is therefore configured so that it conforms to the above-described first clamping region thereof, in order to not clamp locations outside the clamping region. For example, in an embodiment where the first sensor board surface, also referred to as the backside, is completely flat and without any sensors or other electronics, the entire backside may be considered a clamping region, and the sensor board support structure of the base can be configured with a simple flat surface as the sensor board receiving surface. **In** another example, in an embodiment where the first sensor board surface has protrusions from e.g. backside soldering, electronics mounted on that side, or wiring, etc., the first clamping region must conform with the regions between and around protrusions, and thereby the sensor board receiving surface must also conform to these regions.

A surface is considered conforming to a clamping region when it does not extend outside the clamping region within the footprint of the sensor board. **In** other words, a surface is also considered conforming to a clamping region even when it has a smaller area than the clamping region but is within the clamping region, and/or when it extends outside the sensor board area and thus cannot clamp the sensor board.

A clamping arrangement according to the invention is an arrangement of a number of parts that together with the base may clamp the sensor board against the sensor board support structure of the base, i.e. establish a clamping direction and force serving that purpose. One or more parts of the clamping arrangement may also have other purposes, and/or be provided as parts of other condition monitoring elements, such as part of the base, housing, etc., but are herein referred to as part of the clamping arrangement.

A clamping direction according to the invention is the direction of the normal force component of the contact force established at points of contact between the sensor board clamping surface of the clamping head and the second clamping region of the sensor board. The clamping direction is thus perpendicular to the two surfaces at which the clamping force has been established by the clamping arrangement. Due to the clamping arrangement, the force component normal to the two surfaces is never zero and thus the clamping direction is always defined. The two surfaces may advantageously be substantially flat, such that the clamping direction at any point of contact between the sensor board clamping surface and the second clamping region can be defined as a single direction defined by a plurality of parallel force vectors established where the surfaces are in contact.

The clamping arrangement comprises a clamping head and a clamping body which are arranged to slide on each other, and the clamping head is arranged to be in contact with the sensor board. The clamping arrangement is configured so that when the clamping body or clamping head is moved relative to the base in a displacement direction, the clamping head and clamping body are wedged against each other to establish the clamping direction in a different direction, thereby causing the clamping head to clamp the sensor board against the sensor board support structure. Wedging is herein considered in a broad sense as separating or forcing something apart as if with a wedge. One or both of the clamping head and clamping body may be strictly wedge shaped or in a broader sense understood as tapering or having wedge-like sections, or they may either or both have other shapes that are not wedge-shaped at all, but still allow for a wedging action or wedging effect according to the above. Preferably, the clamping arrangement is arranged so that further displacement of the clamping body or the clamping head in the displacement direction causes higher clamping force towards the sensor board.

For example, in an embodiment the clamping body is wedged between the clamping head and a clamping body support structure of the base, so as to push the clamping head away in the clamping direction while the clamping body is wedged in the displacement direction. For example, in an embodiment the clamping head is wedged between a fixed clamping body and the sensor board, so that further wedging of the clamping head in the displacement direction forces the sensor board against the sensor board support structure in the clamping direction. Several other embodiments and options and considerations for clamping arrangements are elaborated below herein.

In other words, the clamping arrangement is configured to transform a displacement of the clamping head or clamping body into a clamping of the sensor board in a different direction than the displacement. This advantageously causes forces from a one-point fastening force, such as a single screw point, to be distributed out in a different direction over an entire clamping area, thereby allowing for distributed fastening of the sensor board over a greater area than a few specific screw locations directly in the sensor board would accomplish.

According to the invention, the clamping of the sensor board in a clamping direction is effectuated by moving the clamping body or clamping head in a displacement direction that is different from the clamping direction. This is contrary to for example fastening the sensor board with a conventional screw through the sensor board, where the screw would be displaced into the sensor board in the same direction as the clamping force achieved thereby. The displacement direction being different from the clamping direction means that according to the invention, the sensor board is clamped in a different direction than the movement of the clamping body or clamping head. This is also herein referred to as clamping angle, i.e. the angle between the displacement direction and the clamping direction. Here a different direction, i.e. clamping angle, is considered at least 30° apart, and in various embodiments the even distribution of clamping force over the sensor board is typically improved with the difference between the directions approaching 90°, such as the clamping angle being in the range of, e.g., 75° - 105°, or approximately perpendicular, i.e. 90°. Angles are understood as also including work tolerances, i.e. +/- a reasonable few percents depending on the specific embodiment and configuration.

A clamping head according to the invention is a part of the clamping arrangement which is in contact with the sensor board during the clamping. In various embodiments, the clamping head may be pressed towards the sensor board by movement in a different direction of the clamping body described below, or by movement in a different direction of the clamping head itself. The clamping head is preferably made of a rigid and impact resistant material, such as metal, ABS polymer, composite, etc., to withstand the clamping force. The clamping head may be one monolithic part or comprised by subparts.

The clamping head has a sensor board clamping surface being in contact with the second sensor board surface and being configured so that it conforms to the above-described second clamping region thereof, in order to not clamp locations outside the clamping region where the vibration sensing element and other protrusions may reside. For example, in an embodiment where the second sensor board surface, also referred to as the frontside, has a number of vibration sensing elements, other sensors or electronics, connectors, etc. protruding at different locations, the second clamping region may comprise the regions between and around protrusions, and thereby the sensor board clamping surface of the clamping head must conform to this second clamping region. As mentioned above, conforming may be understood as at least not extending outside the clamping region within the boundary of the sensor board, but possibly clamping only a part of, or the entire, clamping region.

A clamping body according to the invention is a part of the clamping arrangement which is in contact with the clamping head during the clamping, so that the clamping head can be wedged or otherwise crammed between the clamping body and the sensor board. The clamping body has a head receiving surface in contact with a body receiving surface of the clamping head, and the clamping body and clamping head are configured to be slidably in contact at these surfaces, to allow the clamping body to be displaced along the displacement direction while sliding on the clamping head, or vice versa. The clamping body may in various embodiments be a separate part, for example to be moved in the displacement direction to press the clamping head against the sensor board. In such embodiments, the clamping body may be supported by the base, e.g. a clamping body support structure thereof, or by a fastener, to guide and maintain its position in the clamping direction sufficiently to transfer clamping force towards the sensor board via the clamping head. In various other embodiments, the clamping body may be a monolithic or firmly mounted part of the base, to allow wedging of the clamping head in the displacement direction between the thus fixed clamping body and the sensor board. The clamping body is preferably made of a rigid and impact resistant material, such as metal, ABS polymer, composite, etc., to withstand the clamping force. The clamping body may be one monolithic part or comprised by subparts, or as mentioned be comprised by the base or another main part.

According to the invention, an area of slidable contact defines an area where two surfaces are in mechanical contact and are able to slide against each other. Surfaces sliding against each other can be characterized by either one of the surfaces being displaced with respect to the other or both surfaces being displaced in different directions. Slidable contact means that the two surfaces are at least in partial mechanical contact while sliding. When the head receiving surface of the clamping body is brought into contact with the body receiving surface of the clamping head, an area of slidable contact is established.

According to the invention, the clamping arrangement is arranged to establish the clamping when the clamping body or clamping head is moved relative to the base. During assembly, this movement occurs when the clamping body or clamping head is wedged or otherwise pressed or pulled in between the other parts and thereby establishing a force against the sensor board. For example, in some embodiments, a screw is received in a threaded socket in the base through the clamping body or clamping head, and a tightening of the screw thus presses the respective clamping body or clamping head towards the base, causing the clamping in a different direction to be established as described. When the degree of movement, for example degree of tightening the mentioned example screw, has achieved a sensor board clamping sufficiently strong to achieve the desired vibration transfer characteristics, but without critically damaging the sensor board or clamping arrangement, the movement, such as tightening, is stopped. After assembly, the parts are retained in their final positions by inherent retaining features of the parts or by a clamping arrangement fastener, in order to maintain the desired clamping force of the sensor board.

A prominent feature of the proposed clamping arrangement is the mechanism of converting a contact force from a relatively small area of contact to a contact force at a larger area of contact, thus establishing the clamping force distributed over a larger area at the sensor board. The contact force is initially established between e.g. the clamping arrangement fastener and the clamping body when the clamping arrangement fastener is screwed into the base in an example embodiment. The clamping arrangement causes this force to be partially transferred to the sensor board at the second clamping region. The area of contact between the clamping head and the sensor board may be several times larger than the area of contact between the clamping arrangement fastener and the clamping body. In various embodiments, the area of contact between the clamping head and the sensor board may be twice as large as the area of contact between the clamping arrangement fastener and the clamping head or clamping body. In various embodiments, the area of contact between the clamping head and the sensor board may be in the range of between two and ten times as large as the area of contact between the clamping arrangement fastener and the clamping head or clamping body.

The condition monitoring sensor of the invention, comprising the clamping arrangement that is arranged to establish the clamping when the movement happens, is understood to refer to a condition monitoring sensor having a clamping arrangement that is arranged to achieve this behavior upon the movement, also when the movement has already happened. In other words, the above feature is not considered a process step of moving the clamping body or clamping head, but is considered a feature of a condition monitoring sensor with disassembled unclamped sensor board, partly assembled unclamped sensor board or finally assembled and clamped sensor board.

In an embodiment, a dimension of a cross section of said clamping head and/or said clamping body varies along said displacement direction.

A dimension varying along the displacement direction is a way to transform a movement in the displacement direction to a clamping force in the, different, clamping direction. For example, if the clamping body is wedge shaped, thereby having a varying dimension of its cross section, the combined dimension of the clamping body and clamping head in the clamping direction increases upon moving the clamping body in the displacement direction. If both the clamping body and clamping head have dimensions varying along the displacement direction, they should preferably be designed so that the combined dimension in the clamping direction increases upon movement of the clamping body or clamping head in the displacement direction.

The varying dimension of the cross section along the displacement direction, for example a gradient or tangent line of the variation, may also be considered defining an edge which, at least partially or along tangent lines, is oblique, i.e. non-parallel, relative to the displacement direction. This may also herein be referred to as an oblique surface. As mentioned above, the varying dimension, i.e. the oblique, i.e. non-parallel, surface, may contribute in transforming the movement in the displacement direction into a clamping force in the, different, clamping direction. The area of contact between this oblique surface and another surface may also herein be referred to as a transformation interface. The angle between the displacement direction and the transformation interface or oblique surface, such as a tangent line or gradient thereof, is herein referred to as a transformation interface angle.

In an embodiment, said clamping head and/or said clamping body tapers along or against said displacement direction.

A tapering is an example of varying dimension as described above and may be suitable in various preferred embodiments. A gradient or tangent line of the tapering may, relative to the displacement direction, define a transformation interface angle.

In an embodiment, said clamping head and/or said clamping body is wedge shaped.

Wedge shaped objects may advantageously be simple to design, manufacture and handle, and they have a tapering and varying dimension as described above, thereby being a highly suitable shape for a clamping body and/or a clamping head in various embodiments of the invention. The wedge shape may apply to the entire clamping body and/or clamping head, or only a portion thereof, or several portions thereof. A gradient or tangent line of the wedge shape may, relative to the displacement direction, define a transformation interface angle.

In an embodiment, a transformation interface angle of said clamping arrangement, defined as an angle between said displacement direction and at least one oblique surface or transformation interface of said clamping arrangement, is in the range of 5° - 80°, for example 10° - 50°, 10° - 45°, 10° - 35°, 15° - 30°, 15° - 25°, or, preferably, 15° - 20° or 20° - 30° or 20° - 25°.

As elaborated above, the transformation interface angle may be the angle between the displacement direction and the transformation interface or oblique surface, such as a tangent line or gradient thereof for non-linear transformation interfaces. The size of the transformation interface angle affects the transformation ratio from displacement direction to clamping direction. Angles are understood as also including work tolerances, i.e. +/- a reasonable few percents, such as 1%, 2% or 5%, depending on the specific embodiment and configuration.

In an ideal system with no frictional resistance, the transformation interface angle could be anything between 0° and 90°, endpoints not included, and an angle of 45° would cause the clamping force and movement in the clamping direction and to equal the displacement force and movement in the displacement direction. In a practical system with friction, high transformation interface angles may impede the sliding possibility at the transformation interface, e.g. the sliding of the clamping head and clamping body on each other, and therefore practical transformation interface angles may for example, depending on the materials, be below 50° or even lower.

Further, the transformation interface angle may be determined by considering the tradeoff between the size of movement in the displacement direction, and the resulting size of movement in the clamping direction. For example, in a preferred scenario desiring only a small movement in the clamping direction from a relatively larger movement in the displacement direction, the transformation interface angle should be relatively small, such as, for example, 30° or smaller, such as 25°, 20° or even just 10° - 15°. Thereby a clearly noticeable movement in the displacement direction may cause a much less noticeable movement in the clamping direction, although yet applying an increased clamping force in the clamping direction.

According to the above, relatively small transformation interface angles may serve to accommodate both the real-world frictional issues and the requirement for relatively small movement in the clamping direction upon a noticeable, controllable and tolerant movement in the displacement direction.

For relatively high friction materials, or to achieve a higher resolution of adjustment in the clamping direction, a small transformation interface angle may preferably be selected, such as 5° - 20°, 10° - 15° or 15° - 20°. For relatively smooth surfaces with less friction, or where a lower resolution of adjustment is acceptable, a slightly larger transformation interface angle may preferably be selected, such as 20° - 45°, 20° - 30° or 20° - 25°. For average circumstances or aims, intermediate transformation interface angles may preferably be selected, such as 10° - 35°, 15° - 30° or 15° - 25°.

In an embodiment, said at least one transformation interface is an area of contact between one or more of: said clamping head and said clamping body; said clamping head and said sensor board; said clamping body and said clamping body support structure.

In an embodiment, said at least one oblique surface is one or more surface of: said sensor board clamping surface; said body receiving surface; said head receiving surface; said second sensor board surface; a surface of said clamping body in contact with said clamping body support structure.

Typically, the transformation interface is identical to the area of slidable contact between the clamping head and the clamping body, but in certain embodiments they may designate different interfaces, or there may be a supplementary transformation interface in addition to the area of slidable contact.

In an embodiment, said clamping head and/or said clamping body comprises a material from the list of aluminum, steel, copper, brass, ABS polymer or other rigid polymers, composites, or a combination thereof.

As mentioned above, the clamping head and clamping body should preferably be made from material that is sturdy, rigid and with high impact resistance, so as to withstand the clamping force and transfer, rather than absorb, vibration to not impede the transfer of vibration to the sensor board and the vibration sensing element.

In an embodiment, said body receiving surface is not parallel with said sensor board clamping surface.

The clamping head may have a body receiving surface that is not parallel with its sensor board clamping surface. Such a geometry may facilitate an area of slidable contact between the clamping head and clamping body whereby displacement of the clamping body or clamping head along the displacement direction gives rise to a clamping direction which is different from the clamping body's displacement direction. Tapering or wedge shaped clamping heads are examples of body receiving surfaces not being parallel with the sensor board clamping surface, but can also be achieved by a body receiving surface with a number of protrusions versus a flat sensor board clamping surface, or various curved surface shapes.

In an embodiment, said sensor board clamping surface is parallel with said second sensor board surface.

As part of conforming to the second clamping region of the second sensor board surface, the sensor board clamping surface of the clamping head should preferably be parallel with the second sensor board surface during clamping, i.e. when the condition monitoring sensor has been assembled.

In an embodiment, said sensor board clamping surface is formed by one or more sensor board pressure elements.

Sensor board pressure elements are parts of the clamping head that form the sensor board clamping surface and distributes the clamping force to the sensor board. As the sensor board clamping surface must conform to the second clamping region, and the second sensor board surface in typical embodiments have the vibration sensing element and/or other electronic parts protruding therefrom, the sensor board clamping surface is preferably not a square continuous surface, but comprises a number of sensor board pressure elements, possibly of various dimensions and shapes, and forming separate surfaces or one or more connected surfaces.

In an embodiment, said sensor board pressure elements define at least one clamping head cavity for accommodating said vibration sensing element.

By means of the sensor board pressure elements, one or more rooms for the vibration sensing element and possible other electronic components on the sensor board is established, where the clamping head can apply clamping pressure to the sensor board at the locations of the sensor board pressure elements, i.e. at the second clamping region, while avoiding clamping pressure at the locations of the vibration sensing element and other components. Depending on the design of the sensor board pressure elements, the cavity may fully or partly enclose the vibration sensing element, and possibly further vibration sensing elements, sensors, electronics or other protrusions.

In an embodiment, said sensor board pressure elements are arranged to distribute a clamping force in the clamping direction over an area of the sensor board.

The distribution of clamping force to a clamping region of the sensor board is advantageous over fastening the sensor board only at a few discrete screw locations, as the distributed clamping may achieve reduced rattling and vibration of the sensor board. Further, the distribution of clamping force by the sensor board pressure elements provides for a firm, distributed clamping even with a simple fastening of the clamping body or clamping head, such as with a single screw. In other words, by the present invention, a single fastening operation, e.g. tightening a single screw or pressing a single object into place, achieves the same or better securing of the sensor board to the base, than even several individual screws would achieve in a prior art sensor board fastening method.

In an embodiment, said clamping arrangement comprises a clamping arrangement fastener for fastening said clamping body or said clamping head relative to said base.

By means of the clamping arrangement fastener, the clamping body or clamping head is prevented from moving relative to the rest of the clamping arrangement which prevents the clamping body or clamping head from becoming loose and thereby causing a reduction or elimination of the clamping force.

In an embodiment, said clamping arrangement fastener is a fastener extending through said clamping body or said clamping head, such as a screw or bolt, along said displacement direction.

The clamping arrangement fastener, such as a screw, bolt, rivet, nail or the like, may preferably extend through the clamping body or the clamping head into the base, so the clamping body can be pulled towards the base in the displacement direction, such as towards a clamping retaining region of the base.

In an embodiment, said clamping arrangement fastener is a spring clip, spring or push rod, arranged to assert a force against said clamping body or clamping head along said displacement direction.

A clamping arrangement fastener, such as a spring clip, spring or push rod may advantageously not require additional modification of the clamping body or clamping head such as holes for screws. A spring clip fastener may advantageously be fastened to the base such that the clamping body or clamping head is retained relative to the base. Spring or push rod retainers can be arranged to establish a force against the clamping body or clamping head by e.g. arranging them between a surface of the clamping body or clamping head and some other structure such as an enclosure, whereby a force is established such that the clamping body or clamping head is retained relative to the base.

In an embodiment, said clamping arrangement fastener is formed by friction elements of said clamping body and/or said clamping head.

The friction elements of said clamping body or said clamping head may be formed by modifying e.g. the head receiving and body receiving surfaces. This can be done by e.g. giving the surfaces a rough texture, such that an interlocking effect between the head receiving and body receiving surfaces is achieved when the clamping body or clamping head is displaced along the displacement direction. This may render the use of additional fasteners unnecessary.

In an embodiment, said fastening relative to said base comprises fastening to said base.

The clamping body or clamping head may be fastened directly to the base using some form of fastener such as a screw, bolt, retaining clip or spring. Fastening may be done at different parts of the base such as at a clamping body support structure of the base or at a clamping retaining region of the base.

In an embodiment, said fastening relative to said base comprises fastening to a system component, such as an enclosure or support structure, mounted on said base.

The clamping body or clamping head may be fastened to other system components of the condition monitoring sensor. Other system components may include an enclosure which attaches to the base. A fastener mounted on the enclosure may provide a fastening of the clamping body or clamping head relative to the base by establishing a force that retains the clamping body or clamping head when the enclosure is attached to the base.

In an embodiment, said clamping body is a part of said base.

Alternative to being a separate part, the clamping body may in various embodiments be a monolithic or firmly mounted part of the base, to allow wedging of the clamping head in the displacement direction between the thus fixed clamping body and the sensor board. In such an embodiment, it is the clamping head that is moved relative to the base to establish the clamping direction.

In an embodiment, said displacement direction is different from said clamping direction by a clamping angle of at least 30°, such as in the range of 30° - 150°, for example 45° - 135°, 60° - 120°, 75° - 105°, 80° - 100°, or approximately perpendicular, i.e. 90°.

Although the even distribution of clamping force over the sensor board is typically improved with the difference between the directions approaching 90°, some of the advantages of the invention may be obtained with other clamping angles, even as small as about 30°. Diverging from perpendicular clamping angles may be advantageous for other reasons, e.g. a desired practical arrangement and design of the condition monitoring sensor and its components, or a desired mounting angle of the vibration sensing element or other sensors. Angles are understood as also including work tolerances, i.e. +/- a reasonable few percents, such as 1%, 2% or 5%, depending on the specific embodiment and configuration.

In an embodiment, displacement of said clamping body or said clamping head in the displacement direction causes increasing of a combined dimension of said clamping body and said clamping head in the clamping direction.

As mentioned, the clamping arrangement may be considered transforming a displacement direction into a, different, clamping direction. This transformation may advantageously be achieved by the clamping body and clamping head being configured so that their combined dimension in the clamping direction increases upon moving the clamping body or the clamping head in the displacement direction. This may for example, as described above, be achieved by wedge shapes or other shapes that have a dimension varying along the displacement direction.

In an embodiment, said clamping arrangement fastener is a screw or bolt with its longitudinal axis in a direction not parallel to the clamping direction.

Upon tightening of the fastener in the form of a screw or bolt, the clamping body or clamping head and the fastener are displaced. The fastener may be displaced in a direction parallel to its longitudinal axis. The clamping body or clamping head is displaced along the displacement direction which in turn causes a clamping force to be established in the clamping direction as the clamping body or clamping head slides along the area of slidable contact against the respective clamping head or clamping body. Different designs of the clamping body and clamping head may provide an area of slidable contact which causes the clamping direction to be different from the fastener's displacement direction, which in the case of a screw or bolt is usually parallel and coinciding with its longitudinal axis. Thereby a distributed clamping force on the sensor board may be achieved by tightening a single screw.

In an embodiment, said sensor board does not have any openings through which fasteners are mounted between said first sensor board surface and said second sensor board surface such as holes with screws or retaining clips.

Due to the clamping action established by the clamping arrangement, the use of fasteners such as screws to retain the sensor board may advantageously be unnecessary. This simplifies the sensor board layout such that considerations about the location of openings or holes for fasteners to pass through can be eliminated. This in turn may leave more space for other components on the sensor board. It further simplifies assembly procedures.

In an embodiment, said base comprises a vibration interface for receiving vibrations.

The vibration interface may preferably be designed to fit a suitable location for vibration monitoring on a system such as a machine, bearing, transmission or other mechanical arrangement. The vibration interface may further preferably be configured for the best possible attachment and stiffness under due consideration to, and possible tradeoff with, accessibility, material choice, costs, convenience, etc. Various suitable vibration interfaces are known to the person skilled in the field of condition monitoring.

In an embodiment, said vibration interface comprises threads for mounting.

The vibration interface having threads may achieve a strong mechanical coupling for transfer of vibration signal. The vibration interface can for example be a threaded rod or a nut for receiving a threaded rod.

In an embodiment, said vibration interface comprises a flat surface suitable for magnetic or adhesive mounting.

A vibration interface with a flat surface facilitates mounting of the condition monitoring sensor at a corresponding flat surface on a system to be monitored such as a motor, transmission or bearing using a magnet or some form of adhesive such as epoxy or cement. This ensures a stable mechanical and connection between the condition monitoring sensor's base and the system to be monitored.

In an embodiment, said vibration interface comprises a pointed rod suitable for manual probing.

A vibration interface with a pointed rod may advantageously be used for manual probing of the system to be monitored. Manual probing may entail placing the condition monitoring sensor by hand at a point of mechanical contact with the system to be monitored, such as on a machine's surface or through an opening by which good mechanical contact with internal components such as bearings can be established.

In an embodiment, said base consists of one or more base parts.

A base consisting of one or more base parts may provide benefits such as improved clamping of sensor board, improved support for the clamping body, additional structures for the attachment of fasteners to the clamping body in addition to improved mechanical connection with the system to be monitored at the vibration interface. The base including its base parts may be one monolithic structure, or some of the base parts may be individual, separable parts.

In an embodiment, said base comprises a clamping body support structure.

The clamping body support structure may advantageously provide guiding of the clamping body along the displacement direction.

The clamping body support structure may advantageously function as a backstop for the clamping arrangement whereby displacement of the clamping body in a direction away from the clamping head is restricted.

In an embodiment, said condition monitoring sensor comprises multiple vibration sensing elements.

The sensor board may advantageously have multiple vibration sensing elements mounted on it. This may provide advantages related to the processing of vibration signals from said vibration sensing elements such as efforts to reduce noise or perform some form of spatial or temporal correlation between vibration signals.

In an embodiment, said vibration sensing element can measure vibrations along multiple nonparallel measurement axes.

The vibration sensing element may advantageously be sensitive to vibration along multiple measurement axes such as along two perpendicular axes or three mutually perpendicular axes. The vibration sensing element is thereby able to measure vectors of acceleration in two or three dimensions. Multiple measurement axes become relevant when e.g. a machine under monitoring has been mounted off-balance such that it makes a rocking motion during operation. This rocking motion might extend to three spatial dimensions causing vibration components which may be measured using an accelerometer with three mutually perpendicular axes. Multiple measurement axes also allow for the condition monitoring sensor to be mounted at different orientations on a system to be monitored, while still being able to measure the relevant vibration signal such as parallel or perpendicular to the rotating shaft of a motor.

In an embodiment, said vibration sensing element comprises an integrated circuit contained in a semiconductor package suitable for mounting on said sensor board.

A semiconductor package allows for mounting the vibration sensing element onto the sensor board such as a PCB via some form of bonding such as via soldering. The semiconductor package additionally provides pins for connecting the vibration sensing element to other electronic components on the sensor board such as a socket or circuit traces. The semiconductor package may be one of several different types such as small outline package SOP, quad flat package QFP, ball grid array BGA or land grid array LGA.

In an embodiment, said vibration sensing element comprises a micro-electromechanical system MEMS.

The vibration sensing element may advantageously be a MEMS sensor which provides a low cost and low power device with a small sensor board footprint. The MEMS sensor may be one of several different types that measure vibration according to different principles such as via detecting changes in capacitance or piezoelectric resistivity.

In an embodiment, said vibration sensing element comprises a sensor capable of sensing vibration according to an established measurement principle such as via detecting changes in voltage, capacitance, piezoelectric effect, piezoresistive effect or temperature.

The vibration sensing element may advantageously measure vibration signals according to one or more of several different measurement principles. A piezoelectric vibration sensing element contains a piezoelectric material which when subjected to mechanical stress, such as tension, compression or shear, generates an electrical charge proportional to applied force. A piezoresistive material can also be used to measure vibrations via the change in electrical resistivity when the material is subject to a mechanical load. A vibration sensing element may also measure changes in capacitance that occur when a proof mass connected to a spring experiences vibrations causing the distance between the capacitors plates to vary. Other types of vibration sensing elements may involve measuring other physical quantities such as temperature or light.

In an embodiment, said sensor board is a printed circuit board PCB.

The sensor board may advantageously be a PCB which is a widely available technology able to be manufactured at low costs and at compact sizes. A PCB additionally provides the opportunity for many different circuit designs involving considerations such as electronic component selection and the placement of circuit traces, ground planes and electronic components.

In an embodiment, said sensor board is substantially flat in said first clamping region and/or second clamping region.

The sensor board having a substantially flat surface in the first and/or second clamping regions may provide a number of advantages related to e.g. ease of manufacture of the sensor board and clamping head in addition to providing a suitable distribution of the clamping force uniformly across the first and/or second clamping regions.

In an embodiment, said sensor board does not comprise electronic components in said first clamping region and/or second clamping region.

Electronic components on the sensor board may advantageously be confined to areas outside of the first and second clamping regions. This prevents electronic components on the sensor board from being damaged when the clamping force is applied to the sensor board at the first and second clamping regions. The absence of electronic components may also provide a substantially more flat surface allowing for a better distribution of the clamping force onto the sensor board at the first and second clamping regions.

In an embodiment, said sensor board does not comprise circuit traces in said first clamping region and/or second clamping region.

In a preferred embodiment, the clamping regions are open, i.e. do not completely envelope the vibration sensing element, to allow circuit traces to connect the vibration sensing elements with the further electronics, such as power supply, controllers, communication modules, etc., without being exposed to clamping force. Besides the direct impact of clamping, the nature of a condition monitoring sensor being exposed to vibration and harsh environments over an extended time frame, may further risk damage to circuit traces to expose them to the possibly metallic clamping head and/or sensor board support structure, or even tear them over and disconnecting the vibration sensing element.

Various embodiments may comprise circuit traces crossing the clamping regions, at the outer surfaces of the PCB or in internal layers of the PCB, provided the sturdiness of PCB and circuit traces compared to the nature and extend of clamping force allows for a robust, durable and reliable connection.

In an embodiment, said sensor board comprises two or more sensor boards being clamped by said clamping arrangement.

In various embodiments, in particular with two or more vibration sensing elements, or with other sensors or electronics desired to be mounted close to the base or with a stiff connection to the base and/or vibration interface, instead of mounting all on one sensor board and clamping it according to the invention, they may be distributed on two or more sensor boards, that are clamped according to the invention. This is not to be mixed up with the possibility of having a supplementary board elaborated below.

In an embodiment, said condition monitoring sensor comprises an enclosure suitable for enclosing said vibration sensing element, sensor board, base, clamping arrangement and possibly supplementary electronics.

The enclosure may advantageously be constructed in such a way as to protect the condition monitoring sensor's components from environmental factors such as extreme temperatures, humidity, spills or mechanical shock which may damage or otherwise render the condition monitoring sensor unable to perform its functions.

In an embodiment, said condition monitoring sensor comprises a power supply suitable for providing power to its electronics.

The power supply may advantageously be a rechargeable battery using any type of battery technology such as lithium ion, nickel metal hydride or nickelcadmium. The battery may advantageously be placed inside the condition monitoring sensor's enclosure such that the condition monitoring sensor may function as a portable unit with no need for an externally wired power connection. The battery advantageously allows the condition monitoring sensor to be portable such that it can easily be moved and mounted to different systems to be monitored. **In** other embodiments the power supply may comprise a non-rechargeable battery, a power converter connected to an external power supply such as mains, a connector for an external power supply such as an external power adapter, an energy harvesting device such as a light-to-power, vibration-to-power or heat-to-power transducer, etc.

In an embodiment, said condition monitoring sensor comprises a supplementary board suitable for supplementary electronics.

A supplementary board according to the invention may be any suitable support structure for the supplementary electronics and related electrical connections, such as for example a printed circuit board PCB or a structure created using 3D printing technologies. The supplementary board may advantageously be connected to the sensor board via some form of board-to-board connector or wire which allows for data to be exchanged between e.g. the vibration sensing element and a controller.

In various embodiments, some or all of the supplementary electronics may instead be mounted on the sensor board, for example on an extension of the sensor board.

In an embodiment, said condition monitoring sensor comprises a controller suitable for communication with said vibration sensing element and interfacing with said supplementary electronics.

The controller may be any form of integrated circuit with a minimum of processing and electrical interfacing capability such as a microcontroller, field programmable gate array FPGA, application specific integrated circuit ASIC, digital signal processor DSP, system on a chip SoC or other related devices.

In an embodiment, said condition monitoring sensor comprises a communication module suitable for communication with a backend system.

The communication module may advantageously be any electronic module by which a connection can be established with an external backend system such that data related to e.g. vibration monitoring can be exchanged. The backend system may for example be a server computer with a server software for condition monitoring, a smartphone with a suitable app for reading and visualizing vibration data, etc. The communication module may be integrated in the controller, e.g. a SoC controller, or be a separate module, such as a separate chip.

The communication module may advantageously exchange data with the backend system through a wireless connection offering some form of e.g. serial or parallel data transfer using technologies such as Wi-Fi, mobile cellular network such as 4G or 5G, LoRaWAN, Bluetooth or ZigBee.

The communication module may exchange data with the backend system through a wired connection offering some form of e.g. serial or parallel data transfer using protocols such as internet protocol IP, universal serial bus USB or others.

In an embodiment, said condition monitoring sensor monitors vibrations in a monitored system while being in mechanical contact with said monitored system at said vibration interface.

The monitored system may be any type of system or element of a system subject to vibrations such as a motor, transmission or bearing.

In an embodiment, said condition monitoring sensor is a wireless sensor.

The wireless condition monitoring sensor may advantageously have a battery for supplying power to the electronics and a communication module allowing for wireless communication using technologies such as Wi-Fi, LoRaWAN, Bluetooth or ZigBee. The wireless condition monitoring sensor may be cheap and easy to install as compared to a wired sensor since there is no need to make space or plan for the routing of wires.

In an embodiment, said condition monitoring sensor is retrofitted to a monitored system such that vibrations are monitored while being in mechanical contact with said monitored system at said vibration interface.

The condition monitoring sensor may advantageously be mounted onto a system to be monitored after said system has been manufactured. This retrofitting may involve creating a suitable mechanical interface onto which the condition monitoring sensor may be mounted. Or the condition monitoring sensor may simply be mounted on a relatively flat surface of the system using some suitable means of fastening such as a magnet, epoxy or cement.

In an embodiment, said condition monitoring sensor is integrated into a monitored system during manufacture of said monitored system.

During manufacture of motors, bearings and other systems where condition monitoring may be relevant, the condition monitoring sensor of the present invention may advantageously be integrated during manufacture. Thereby the sensor board may for example be clamped directly to a machine part serving as the base.

The invention further relates to a method of fastening a sensor board in a condition monitoring sensor, the method comprising steps of providing a sensor board comprising a first sensor board surface with a first clamping region and a second sensor board surface with a second clamping region, and said sensor board having a vibration sensing element mounted thereon; providing a base comprising a sensor board support structure having a sensor board receiving surface conforming to said first clamping region; providing a clamping arrangement comprising a clamping head and a clamping body; said clamping head having a sensor board clamping surface conforming to said second clamping region and a body receiving surface, and said clamping body having a head receiving surface; establishing a clamping direction to clamp said sensor board between said clamping head and said sensor board support structure by sequentially or partly simultaneously performing the following steps: placing said sensor board with said first clamping region against said sensor board receiving surface; placing said clamping head with said sensor board clamping surface against said second clamping region; placing said clamping body with said head receiving surface slidably in contact with said body receiving surface; establishing said clamping direction by moving said clamping body or said clamping head relative to said base along a displacement direction different from said clamping direction, whereby said head receiving surface and said body receiving surface slide on each other.

The sensor board fastening method of the invention may achieve the advantages described above relating to the condition monitoring sensor, such as resulting in a stable and efficient mechanical connection between the base of the condition monitoring sensor, such as a vibration sensor, and the sensor board holding the vibration sensing element thereof.

The fastening method of the invention allows a simple and fast assembling of a condition monitoring sensor. The simple fastening method is further in preferred embodiments likewise simply reversible, so that errors detected during assembly can easily be corrected, and errors or damages occurring during use may be repaired.

The fastening method of the invention allows for efficient assembling and use of a condition monitoring sensor, and thereby be advantageous for use in monitoring of mechanical systems where reliability and high uptime is important for safety and/or productivity. The efficiency in use, such as high usability and accuracy, may ensure reliability and allow for detection of a wide range of errors or instabilities. The efficiency in assembling may allow for cost reduction and repairing, thereby making it feasible to apply condition monitoring sensors, such as vibration sensors, permanently at more monitoring sites, such as more motors, bearings, transmissions and other industrial assets, to achieve a high degree of vibration monitoring in a crucial production.

In an embodiment, said condition monitoring sensor is the condition monitoring sensor according to any one of the above.

All the advantages, elaborations, embodiments and examples described with relation to the condition monitoring sensor also apply to the method of fastening the sensor board in the condition monitoring sensor.

The invention further relates to a method of removing the sensor board from the condition monitoring sensor of any one of the above, the method comprising steps of: moving said clamping body or said clamping head relative to said base along the opposite of the displacement direction, thereby releasing the clamping direction; and removing said sensor board from said sensor board receiving surface.

The sensor board removal method of the invention is highly efficient and simple due the specific clamping arrangement and other configuration of the condition monitoring sensor of the invention. This allows for feasible repair and maintenance, with benefits for efficiency, costs and sustainability.

### The drawings

Various embodiments of the invention will in the following be described with reference to the drawings where
figs. 1a - 1e illustrate different views of a condition monitoring sensor according to an embodiment of the invention,
figs. 2a - 2b illustrate different condition monitoring sensors according to two different embodiments,
figs. 3a - 3d illustrate different sensor boards and their corresponding second clamping regions according to different embodiments,
figs. 4a - 4f illustrate condition monitoring sensors with different clamping arrangements according to different embodiments of the invention,
figs. 5a - 5d illustrate different ways of mounting a condition monitoring sensor and different systems on which it may be mounted according to different embodiments,
figs. 6a - 6f illustrate different embodiments of clamping arrangement and clamping heads according to different embodiments of the invention, and
figs. 7a - 7b illustrate respectively a perspective view and a perspective sectional view of an embodiment of the condition monitoring sensor.

### Detailed description

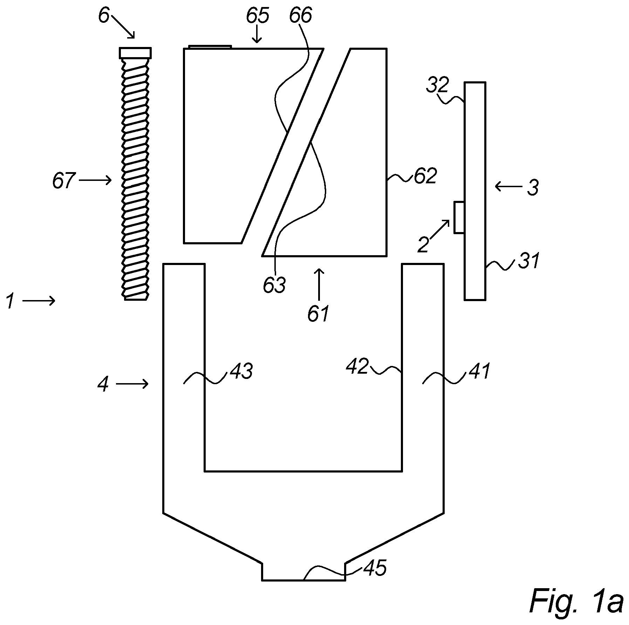

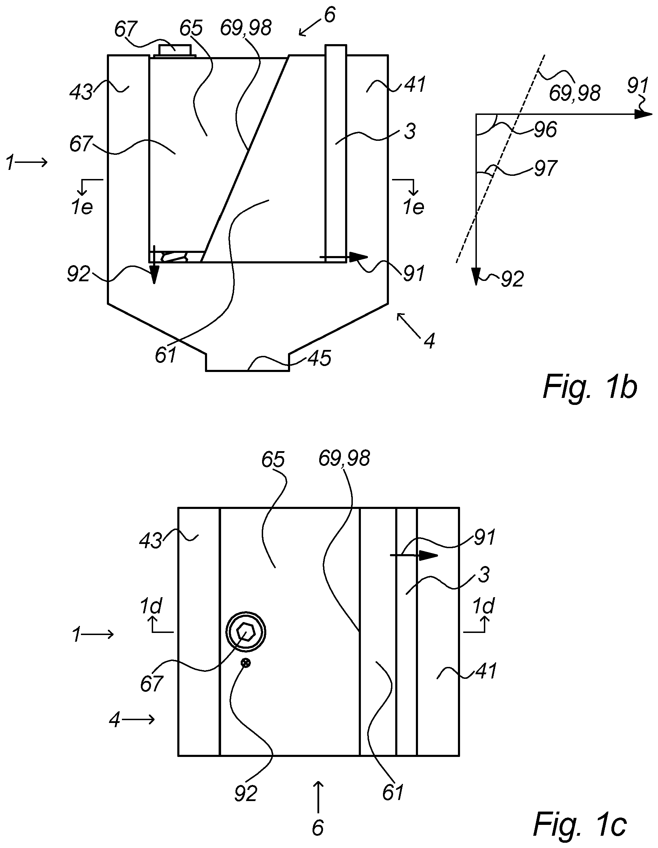

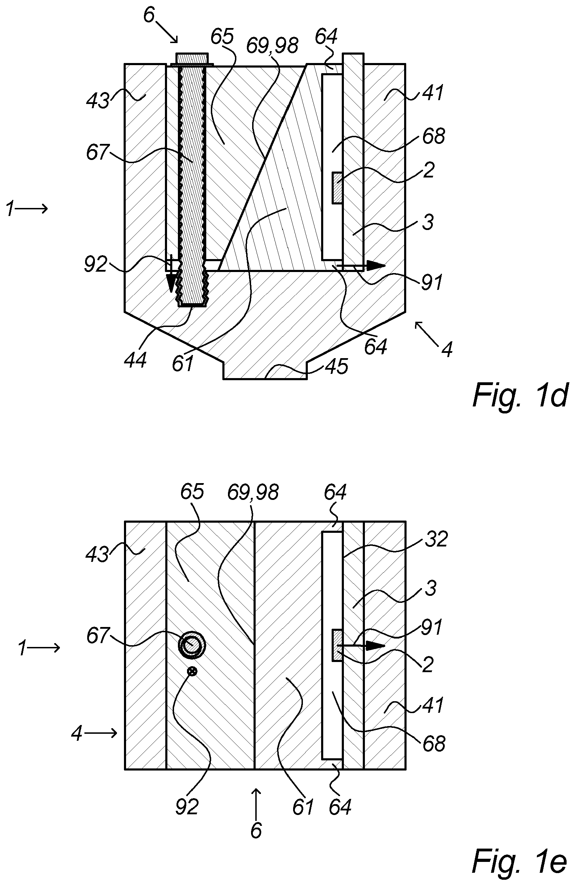

Figs. 1a - 1e illustrate an embodiment of a condition monitoring sensor 1, such as a vibration sensor, according to the disclosure. Figs. 1 - 1e are different views of the same embodiment, and are all simplified to emphasize various features of primarily the mounting of a sensor board 3 in a condition monitoring sensor 1. The person skilled in the field of condition monitoring sensors will know to apply further features not shown here but related to other aspects of condition monitoring sensors which may be relevant or even necessary for ordinary use.

Figs. 1a and 1b are, respectively, an exploded view and an assembled view seen from the side, fig. 1c is an assembled view seen from the top, figs. 1d and 1e are sectional views seen from, respectively, the side and the top.

Condition monitoring sensors, such as the condition monitoring sensor 1 of figs. 1a - 1e, are designed to measure or monitor parameters, e.g. vibration, via a vibration interface 45 in contact with a system to be monitored 93 (not shown), preferably by a firm mounting thereon. The vibration interface 45 may, as shown in this embodiment, be part of a base 4 of the condition monitoring sensor 1.

Fig. 1a illustrates a side view of the condition monitoring sensor 1 with each part shown separately for improved intelligibility, such as before the condition monitoring sensor 1 has been assembled. For vibration or acceleration measurements or monitoring, the condition monitoring sensor 1 comprises a vibration sensing element 2 mounted on a sensor board 3 using some form of bonding material such as solder. The sensor board 3 comprises a first sensor board surface 31 and a second sensor board surface 32. The condition monitoring sensor 1 further comprises a base 4 and a clamping arrangement 6 for fixing the sensor board 3 relative to the base 4.

The clamping arrangement 6 comprises a clamping head 61, a clamping body 65 and a clamping arrangement fastener 67. The clamping head 61 has a sensor board clamping surface 62 for clamping the sensor board 3 once assembled. The clamping head 61 and clamping body 65 have respectively a body receiving surface 63 and a head receiving surface 66 where mechanical contact is made when the condition monitoring sensor 1 has been assembled. The clamping arrangement fastener 67 is shown in this embodiment as a screw but may comprise any other suitable fastener means.

The base 4 comprises several regions and surfaces which support the functionality and interaction with other parts of the condition monitoring sensor 1. These include a sensor board support structure 41 with a sensor board receiving surface 42 for receiving and supporting the sensor board 3, a clamping body support structure 43 for supporting the clamping body 65, and a vibration interface 45 for mechanically interfacing with a monitored system 93 (not shown).

Fig. 1b illustrates a side view of the condition monitoring sensor 1 in an assembled configuration (left side of figure) along with the directions, angles and lines that define the operation of the clamping arrangement 6 (right side of figure). The sensor board 3 has been clamped against the sensor board support structure 41 by the clamping head 61 which together with the clamping body 65 has established a clamping direction 91 when the clamping body 65 has been fastened to the base 4 using the clamping arrangement fastener 67. Tightening of the clamping arrangement fastener 67 has caused the clamping body 65 to move slightly in the displacement direction 92 guided by the clamping body support structure 43 of the base 4 and the area of slidable contact 69 between the clamping body 65 and the clamping head 61. The vibration sensing element 2 (not shown) is obscured in this view by the clamping head 61, as the vibration sensing element is in fact accommodated in a clamping head cavity 68 (see e.g. the sectional view on fig. 1d) to avoid clamping force on the vibration sensing element itself, as explained later. Section lines 1e-1e indicate the sectioning plane and direction of the sectional view illustrated on fig. 1e.

The clamping arrangement 6 illustrated on fig. 1b has a clamping angle 96 of approximately 90° and a transformation interface angle 97 of approximately 20° as illustrated. The transformation interface 98 is in this embodiment the same as the area of slidable contact 69, and its oblique surfaces are the body receiving surface 63 (fig. 1a) of the clamping head 61 and the head receiving surface 66 (fig. 1a) of the clamping body 65.

Fig. 1c illustrates a top view of the assembled condition monitoring sensor 1 of fig. 1b. The sensor board 3 is shown clamped between the sensor board support structure 41 of the base 4 and the clamping head 61. The clamping direction 91 has as described above been established by tightening the clamping arrangement fastener 67 such that the clamping body 65 has moved in the displacement direction 92 between the clamping body support structure 43 and the clamping head 61 at the area of slidable contact 69 between the head receiving surface 66 (fig. 1a) of the clamping body 65 and the body receiving surface 63 (fig. 1a) of the clamping head 61. As in fig. 1b, the vibration sensing element 2 (figs. 1a, 1d and 1e) cannot be seen because it is accommodated inside the clamping head cavity 68 (figs. 1d and 1e). Section lines 1d-1d indicate the sectioning plane and direction of the sectional view illustrated on fig. 1d.

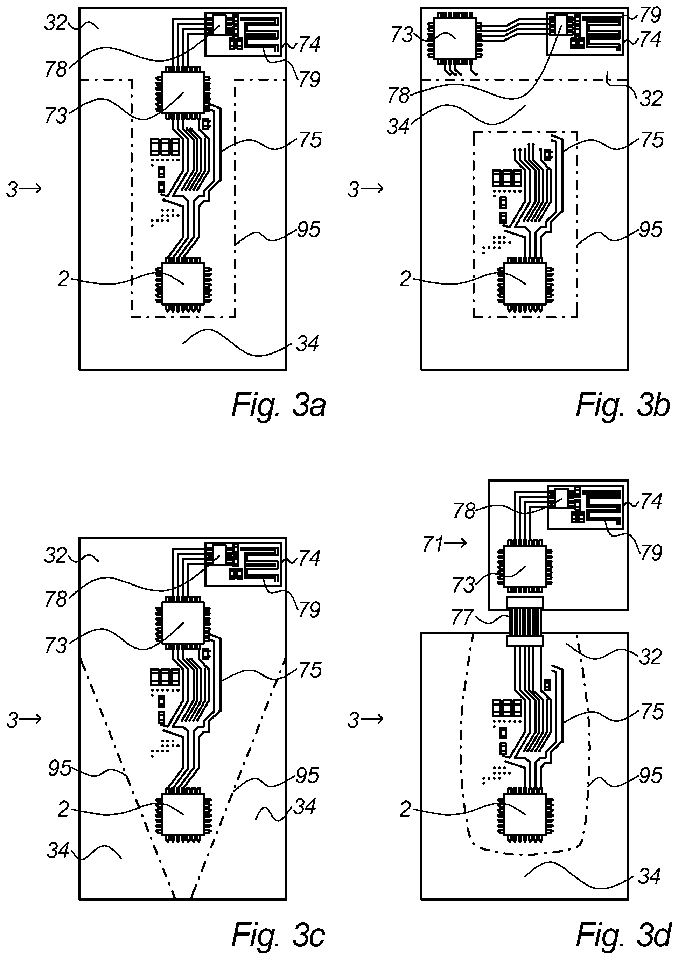

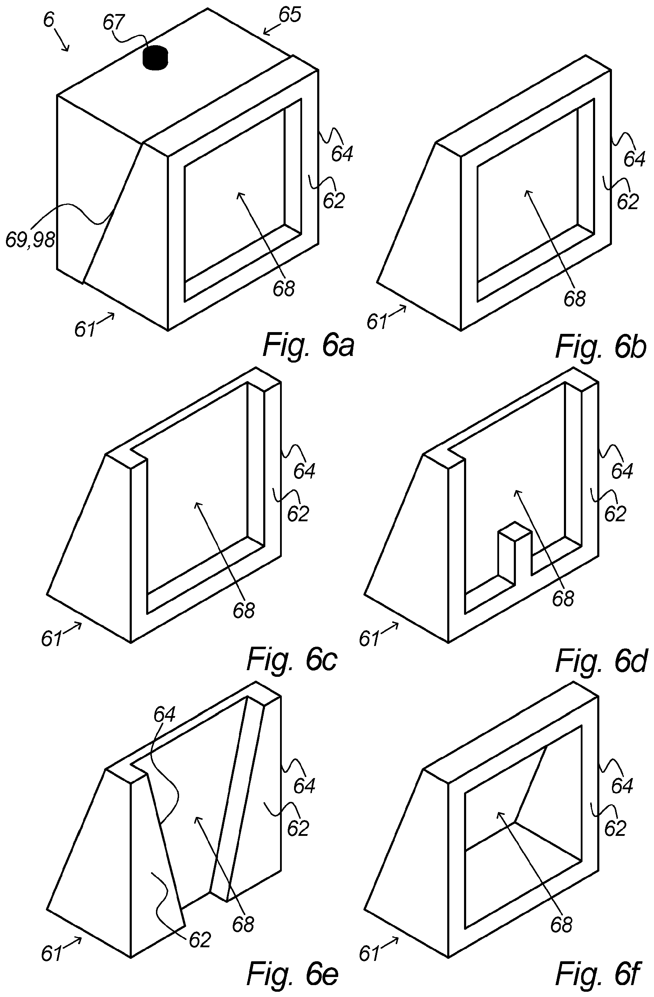

Fig. 1d illustrates a sectional side view of the condition monitoring sensor 1 taken at the sectioning plane and in the direction indicated by section lines 1d-1d on fig. 1c. The sectional view illustrates how the clamping arrangement fastener 67 passes through the clamping body 65 and attaches to the clamping retaining region 44, here illustrated as a threaded hole in the base 4. The clamping arrangement fastener 67 ensures that once the clamping body 65 has been moved in the displacement direction 92, it cannot move relative to the base 4. This ensures that clamping of the sensor board 3 is maintained even when the condition monitoring sensor 1 is subject to vibrations. As further seen on this sectional side view, the clamping head 61 forms a clamping head cavity 68 to accommodate the vibration sensing element 2 and possibly other electronic components protruding from the sensor board 3. The clamping head cavity 68 is formed by a number of sensor board pressure elements 64 of the clamping head 61. The clamping head 61 is shown to be in contact with the second sensor board surface 32 only at the location of the sensor board pressure elements 64 of the clamping head 61, thereby forming the clamping head cavity 68 and protecting protruding components of the sensor board at other locations from being clamped. The sensor board pressure elements 64 transfer the force of the clamping direction 91 established by the displacement of the clamping body 65 to the sensor board 3, and ensure a distribution of this force over an area of the sensor board 3 corresponding to the sensor board clamping surface 62 (figs. 6a - 6f). Further description and various alternative embodiments of distribution of clamping force by means of sensor board pressure elements 64 and clamping head cavity 68 are provided below with reference to figs. 3a - 3d and 6a - 6f, any of which may be combined with the embodiment described here with reference to figs. 1a - 1e.

Fig. 1e illustrates a sectional top view of the condition monitoring sensor 1 taken at the sectioning plane and in the direction indicated by section lines 1e-1e on fig. 1b. The sectional view illustrates the clamping head cavity 68 formed by the sensor board pressure elements 64 and the vibration sensing element 2 contained therein. The clamping head 61 is shown to be in contact with the second sensor board surface 32 only at the location of the sensor board pressure elements 64. The clamping head cavity 68 may as shown have space for not only the vibration sensing element 2 but also for supplementary electronics 7 (not shown) such as additional sensors.

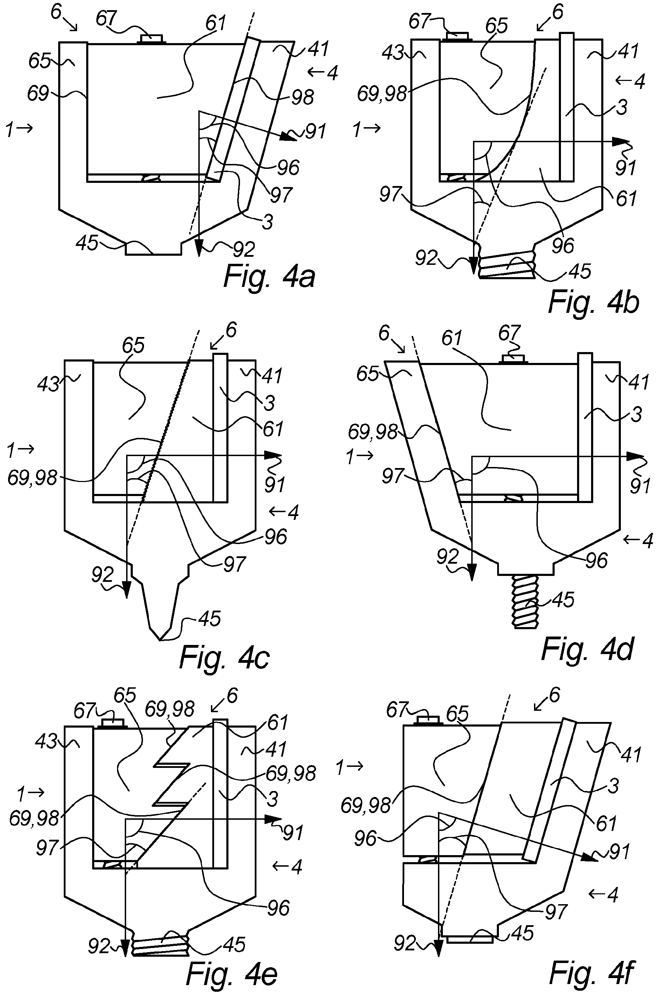

Figs. 1a - 1e illustrate the condition monitoring sensor 1 after it has been assembled and clamping of the sensor board 3 has been established. Clamping of the sensor board 3 is established when the clamping arrangement fastener 67 is tightened such that the clamping body 65 is displaced slightly in the displacement direction 92. Due to the wedge-shape of the clamping body 65 illustrated on figs. 1a - 1e, its displacement causes a force to be established in a direction different from the displacement direction 92. The direction of this force is in the clamping direction 91 and is applied to the sensor board 3 via the sensor board pressure elements 64 of the clamping head 61. Different embodiments of a wedge-shaped clamping body 65 such as the one illustrated on figs. 1a - 1e are shown on figs. 4a - 4f.

The established clamping of the sensor board 3 as shown on figs. 1a - 1e has advantages related to the bandwidth and resonance frequency of the condition monitoring sensor 1. Clamping of the sensor board 3 ensures a firm mechanical connection between the sensor board 3 and the base 4 which in turn reduces attenuation of vibration signals and ensures that the condition monitoring sensor 1 has a sufficiently high resonance frequency to achieve a desired bandwidth.

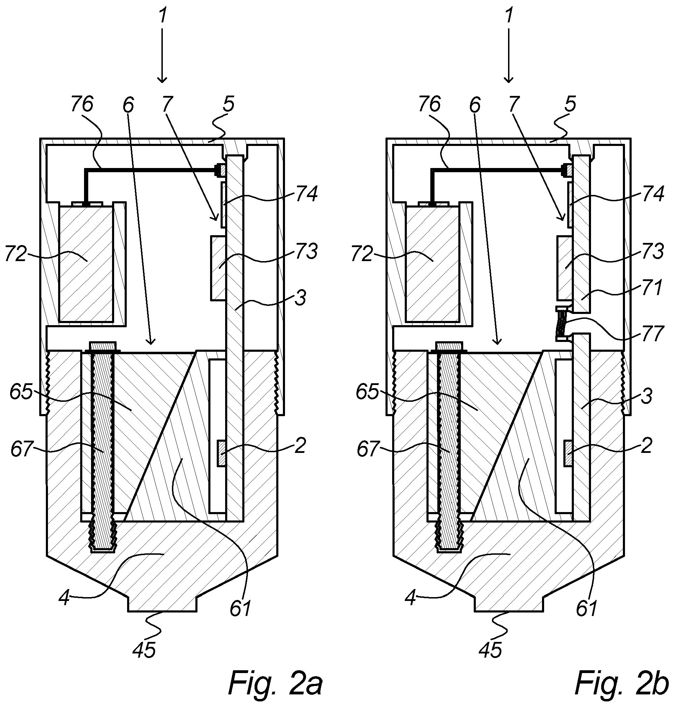

Figs. 2a and 2b illustrate different embodiments of a condition monitoring sensor 1 according to the disclosure. Figs. 2a and 2b show additional features that may optionally be comprised by the condition monitoring sensor 1, that were not shown on figs. 1a - 1e. The most important additional feature of figs. 2a and 2b as compared to figs. 1a - 1e is the inclusion of an enclosure which may protect the internal components from environment and house additional components such as a power supply 72 and a controller 73.

Figs. 2a and 2b are both assembled sectional side views of the condition monitoring sensor 1 similar to the sectional view seen on fig. 1d.

Fig. 2a illustrates a sectional side view of an assembled condition monitoring sensor 1 with an enclosure 5. The enclosure 5 covers and protects the components of the condition monitoring sensor 1 such as the vibration sensing element 2, sensor board 3, clamping arrangement 6 and supplementary electronics 7. The enclosure 5 is shown mounted on the base 4 using threads, but other forms of mounting such as using spring clips, screws or adhesive may also be considered. The enclosure 5 houses the power supply 72 here illustrated as a battery with a wire 76 which is attached to the sensor board 3 with a connector such that power can be provided to the electronic components of the condition monitoring sensor 1. Supplementary electronics 7 in the form of a controller 73 and a communication module 74 are shown mounted on the sensor board 3.

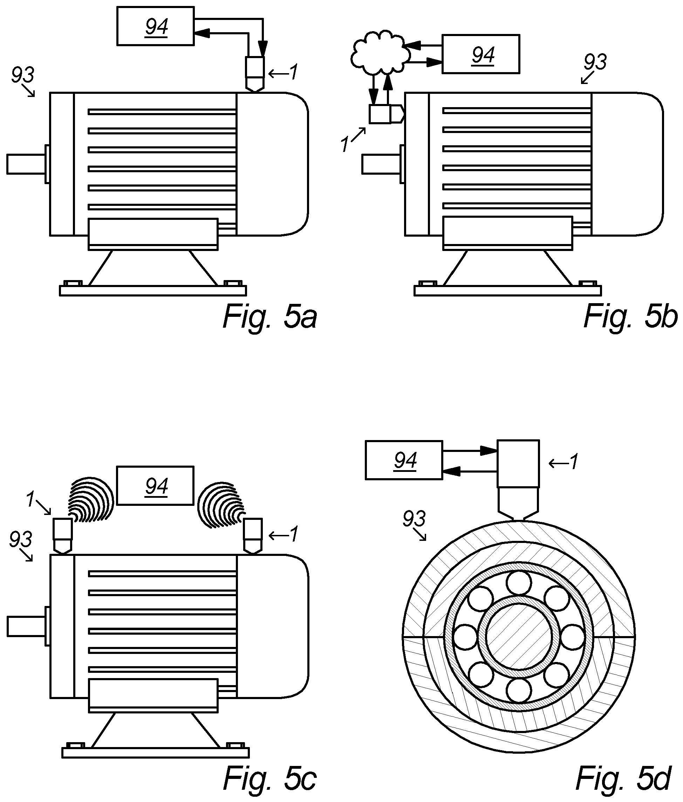

The vibration sensing element 2, controller 73 and communication module 74 are connected via circuit traces 75 (figs. 3a - 3d) on the sensor board 3 such that e.g. the vibration sensing element 2 can transfer sensor data to the controller 73 which can then transfer data to the communication module 74 which may transmit this data using some form of wireless communication means such as to a backend system 94 (fig. 5a - 5d). The communication module 74 may also receive data, e.g. settings or firmware, such as wirelessly from the backend system 94 which can then be transferred to the controller 73 and possibly on to the vibration sensing element 2. In this and the other embodiments herein, the controller 73 and communication module 74 may also be integrated as a single controller with communication capabilities, e.g. a system-on-chip SoC, or there may be further controllers, communication modules, or other electronics. The sensor board 3 has been clamped by the clamping arrangement 6 consisting of the clamping head 61, clamping body 65 and clamping arrangement fastener 67. The clamping arrangement fastener 67 is in this embodiment illustrated as a screw attached to the base 4 at the clamping retaining region 44, but fastening may be done using other means such as using spring clips. The condition monitoring sensor 1 is attachable to a system to be monitored 93 (fig. 5a - 5d) at the vibration interface 45 of the base 4.

Fig. 2b illustrates a sectional side view of an assembled condition monitoring sensor 1 with an enclosure 5 similar to fig. 2a. The enclosure 5 covers and protects the condition monitoring sensor's components, which in addition to those shown on fig. 2a now include a supplementary board 71. The enclosure 5 is attached to the base in an identical way as that shown on fig. 2a. The supplementary board 71 is connected to the sensor board 3 via a board-to-board connector 77, such as via a flat flexible cable, a cable assembly or individual wires. Supplementary electronics 7 in the form of a controller 73 and a communication module 74 are shown mounted on the supplementary board 71, whereas the vibration sensing element 2 is mounted on the sensor board 3. The vibration sensing element 2, controller 73 and communication module 74 are connected via circuit traces 75 (fig. 5a - 5d) on the sensor board 3 and supplementary board 71. The board-to-board connector 77 ensures that electronic signals can be transferred between components on the sensor board 3 and the supplementary board 71, while transfer of vibrations between the two boards is impeded.

Figs. 3a - 3d illustrate different embodiments of the sensor board 3 and its corresponding second clamping region 34. The embodiments illustrate how the shape of the second clamping region 34 can be different with different layouts of electronic components and different designs of the clamping head 61 (figs. 6a - 6f). Electronic components illustrated on figs. 3a - 3d including the vibration sensing element 2, controller 73, communication module 74 and circuit traces 75, are merely shown schematically for purposes of illustration and do not necessarily correspond to a practical implementation or layout of sensor board components.

Figs. 3a - 3d illustrate the second clamping region 34. However, figs. 3a - 3d may equivalently be interpreted as illustrating the first clamping region on the first sensor board surface 31. In such an embodiment, the sensor board support structure 41 is arranged to present a sensor board clamping surface equivalent to those illustrated on figs. 3a - 3d i.e. a surface which provides a cavity and sensor board pressure elements when pressed against the first sensor board surface 31. If the first sensor board surface 31 or the second sensor board surface 32 contains no components or circuit traces, the sensor board clamping surface 62 of the clamping head 61 can be embodied as a completely flat surface which is clamped against the sensor board 3. The sensor board support structure 41 of the base 4 may thus be embodied with sensor board pressure elements, a sensor board clamping surface and a clamping cavity identical to the clamping heads 61 illustrated on figs. 6a - 6f.

Fig. 3a illustrates the sensor board 3 and its second sensor board surface 32 with electronic components shown schematically. The vibration sensing element 2 and the controller 73 are shown as semiconductor packages with pins soldered to the sensor board 3. The communication module 74 is illustrated as comprising a radio-frequency transceiver semiconductor package 78 and an antenna 79. Circuit traces 75 illustrate the electrical connection and communication between the vibration sensing element 2, controller 73 and communication module 74. The second clamping region 34 of the sensor board 3 is illustrated as an area with its boundary delimited by lines 95 showing the bounds of the second clamping region 34. In this embodiment, the second clamping region 34 forms one contiguous region on the second sensor board surface 32. The shape of the second clamping region 34 corresponds with the sensor board clamping surface 62 (not shown) of a matching clamping head 61 (not shown) such as an embodiment similar to the one shown on fig. 6c.

Fig. 3b illustrates the sensor board 3 and its second sensor board surface 32 with electronic components shown schematically as in fig. 3a. In this embodiment, some circuit traces are placed in deeper layers of the sensor board 3 and are therefore not shown, such as those connecting the vibration sensing element 2 and the controller 73. The second clamping region 34 of the sensor board 3 is illustrated as an area with its boundary delimited by lines 95 indicating the bounds of the second clamping region 34. The second clamping region 34 forms one contiguous region on the second sensor board surface 32, and in this embodiment it completely encircles the vibration sensing element 2, which is possible due to the circuit traces 75 being placed in deeper layers of the sensor board 3. A clamping head 61 (not shown) embodiment which approximately matches the shape of the second clamping region 34 can be seen on fig. 6b.

Fig. 3c illustrates the sensor board 3 and its second sensor board surface 32 with electronic components shown schematically as in fig. 3a and 3b. In this embodiment, the second clamping region 34 of the sensor board 3 is illustrated as two areas delimited by lines 95 that indicate the bounds of the second clamping region 34. The second clamping region 34 thus forms two separate areas with a triangular shape on the second sensor board surface 32. A clamping head 61 embodiment which approximately matches the shape of the second clamping region 34 shown on fig. 3c can be seen on fig. 6e.

Fig. 3d illustrates the sensor board 3 and a supplementary board 71 with the second sensor board surface 32 being visible. A board-to-board connector 77 provides an electrical connection between the sensor board 3 and the supplementary board 71 allowing for data to be transferred between the vibration sensing element 2 and the controller 73. Circuit traces 75 connect the vibration sensing element 2 to the board-to-board connector 77 on the sensor board 3. On the supplementary board 71, circuit traces 75 ensure electrical connection between the controller 73 and the board-to-board connector 77 and between the controller 73 and the communication module 74. The second clamping region 34 of the sensor board 3 is illustrated as an area delimited by lines 95 which indicate the boundary of the second clamping region 34. The second clamping region 34 forms one contiguous region on the second sensor board surface 32, but the boundary lines are curved instead of straight lines as in the embodiments shown on figs. 3a - 3c. It is noted that the feature of having a supplementary board 71 may as readily understood by the skilled person also be implemented with respect to any of the other embodiments of clamping region design, or other embodiments described herein.

Figs. 4a - 4f illustrate different embodiments of a condition monitoring sensor 1, such as a vibration sensor, according to the disclosure. Figs. 4a - 4f are all simplified to emphasize primarily the clamping arrangement 6 of the condition monitoring sensor 1. The embodiments illustrate different ways of designing the clamping arrangement 6 such that the sensor board 3 is clamped between the sensor board support structure 41 and the clamping head 61. The different clamping arrangements 6 give rise to different clamping angles 96 between the clamping direction 91 and displacement direction 92 and different transformation interface angles 97 between the displacement direction 92 and at least one of the surfaces of the clamping arrangement 6. Different types of vibration interfaces 45, where the condition monitoring sensor 1 is mechanically connected to a monitored system 93, are also illustrated. The person skilled in the field of condition monitoring sensors will know to combine the features of the different embodiments, and/or apply further features not shown here but related to other aspects of condition monitoring sensors which may be relevant or even necessary for ordinary use.

Fig. 4a illustrates a side view of a condition monitoring sensor 1 in an assembled configuration. The clamping arrangement 6 is illustrated with a clamping head 61, clamping body 65 and clamping arrangement fastener 67. The clamping body 65 is shown to be a monolithic part of the base 4 in this embodiment. The sensor board 3 has been clamped against the sensor board support structure 41 by the clamping head 61 which via the clamping body 65 has established a clamping direction 91 when the clamping head 61 is fastened to the base 4 using the clamping arrangement fastener 67. Tightening of the clamping arrangement fastener 67 has caused the clamping head 61 to move slightly in the displacement direction 92 guided by the clamping body 65 and the area of slidable contact 69 between the clamping body 65 and the clamping head 61. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 is shown as a flat surface at which the condition monitoring sensor 1 may be mounted to a system to be monitored 93 (figs. 5a - 5d) by using some form of adhesive such as epoxy or cement.

The clamping arrangement 6 illustrated on fig. 4a has a clamping angle 96 of approximately 70° and a transformation interface angle 97 of approximately 20°. The area of slidable contact 69 is established between the head receiving surface 66 (not shown) of the clamping body 65 and the body receiving surface 63 (not shown) of the clamping head 61. The transformation interface 98 is established between the oblique surfaces of the sensor board clamping surface 62 (not shown) of the clamping head 61 and the second clamping region 34 (not shown) of the sensor board 3.

Fig. 4b illustrates a side view of a condition monitoring sensor 1 in an assembled configuration. The clamping arrangement 6 is illustrated with a clamping head 61, clamping body 65 and clamping arrangement fastener 67, and the area of slidable contact 69 forming a curve as illustrated. The sensor board 3 is clamped against the sensor board support structure 41 by the clamping head 61 which via the clamping body 65 has established a clamping direction 91 when the clamping body 65 is fastened to the base 4 using the clamping arrangement fastener 67. Tightening of the clamping arrangement fastener 67 has caused the clamping body 65 to move slightly in the displacement direction 92 guided by the clamping body support structure 43 of the base 4 and the area of slidable contact 69 between the clamping body 65 and the clamping head 61. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 has a number of threads by which the condition monitoring sensor 1 may be affixed to e.g. a tapped hole on a system to be monitored 93 (figs. 5a - 5d) for transfer of vibrations to the condition monitoring sensor 1.

The clamping arrangement 6 illustrated on fig. 4b has a clamping angle 96 of approximately 90°. The transformation interface angle 97 varies across the area of slidable contact in an approximate interval between 5° to 65°. The transformation interface angle 97 illustrated on fig. 4b is taken at a point on the area of slidable contact 69 where the transformation interface angle 97 is approximately 20°. The area of slidable contact 69 is the same as the transformation interface 98, and its oblique surfaces are the body receiving surface 63 (not shown) of the clamping head 61 and the head receiving surface 66 (not shown) of the clamping body 65.

Fig. 4c illustrates a side view of a condition monitoring sensor 1 in an assembled configuration. The clamping arrangement 6 is illustrated with a clamping head 61 and clamping body 65. The head receiving surface of the clamping body 66 and the body receiving surface of the clamping head 63 are rough and uneven such that an interlocking effect by friction has been established between the clamping body 65 and the clamping head 61 at the area of slidable contact 69. The sensor board 3 is clamped against the sensor board support structure 41 by the clamping head 61, which via the clamping body 65 establishes a clamping direction 91 when the clamping body 65 has been forced in the displacement direction 92 guided by the clamping body support structure 43 and the area of slidable contact 69. Due to the interlocking and friction effects between the clamping body 65 and the clamping head 61 at the area of slidable contact 69, the clamping body 65 is able to maintain its position relative to the base without the use of a fastener. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 tapers to form a probe point which can be brought into mechanical contact with a system to be monitored 93 (figs. 5a - 5d) for transfer of vibrations to the condition monitoring sensor 1.

The clamping arrangement 6 illustrated on fig. 4c has a clamping angle 96 of approximately 90° and a transformation interface angle 97 of approximately 20°. The area of slidable contact 69 is the same as the transformation interface 98, and the oblique surfaces are the body receiving surface 63 (not shown) of the clamping head 61 and the head receiving surface 66 (not shown) of the clamping body 65.

Fig. 4d illustrates a side view of a condition monitoring sensor 1 in an assembled configuration. The clamping arrangement 6 is illustrated with a clamping head 61, clamping body 65 and clamping arrangement fastener 67. The clamping body 65 is shown to be a monolithic part of the base 4 in this embodiment. The sensor board 3 is clamped against the sensor board support structure 41 by the clamping head 61 which via the clamping body 65 establishes a clamping direction 91 when the clamping head 61 is fastened to the base 4 using the clamping arrangement fastener 67. Tightening of the clamping arrangement fastener 67 has caused the clamping head 61 to move slightly in the displacement direction 92 guided by the clamping body 65 and the area of slidable contact 69 between the clamping body 65 and the clamping head 61. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 is illustrated as having a tapped hole into which a threaded rod has been inserted. The threaded rod may subsequently be affixed to a system to be monitored 93 (figs. 5a - 5d) for transfer of vibrations to the condition monitoring sensor 1.

The clamping arrangement 6 illustrated on fig. 4d has a clamping angle 96 of approximately 90° and a transformation interface angle 97 of approximately 15°. The area of slidable contact 69 is the same as the transformation interface 98, and its oblique surfaces are the body receiving surface 63 (not shown) of the clamping head 61 and the head receiving surface 66 (not shown) of the clamping body 65.

Fig. 4e illustrates a side view of a condition monitoring sensor 1 in an assembled configuration. The clamping arrangement 6 is illustrated with a clamping head 61, clamping body 65 and clamping arrangement fastener 67. The area of slidable contact 69 between the clamping body 65 and the clamping head 61 is shown to have gaps due to the shape of the head receiving surface of the clamping body 66 (not shown) and the body receiving surface of the clamping head 63 (not shown) combined with the displacement of the clamping body 65 in the displacement direction 92. The sensor board 3 is clamped against the sensor board support structure 41 by the clamping head 61 which via the clamping body 65 establishes a clamping direction 91 when the clamping body 65 has been fastened to the base 4 using the clamping arrangement fastener 67. Tightening of the clamping arrangement fastener 67 has caused the clamping body 65 to move slightly in the displacement direction 92 guided by the clamping body support structure of the base 43 and the area of slidable contact 69 between the clamping body and the clamping head 61. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 has a number of threads by which the condition monitoring sensor 1 may be affixed to e.g. a tapped hole on a system to be monitored 93 for transfer of vibrations to the condition monitoring sensor 1.

The clamping arrangement 6 illustrated on fig. 4e has a clamping angle 96 of approximately 90° and a transformation interface angle 97 of approximately 40°. The area of slidable contact 69 is the same as the transformation interface 98, and its oblique surfaces are the body receiving surface 63 (not shown) of the clamping head 61 and the head receiving surface 66 (not shown) of the clamping body 65.

Fig. 4f illustrates a side view of a vibration sensor 1 in an assembled configuration. The clamping arrangement 6 is illustrated with a clamping head 61, clamping body 65 and clamping arrangement fastener 67. The sensor board 3 is clamped against the sensor board support structure 41 by the clamping head 61 which via the clamping body 65 establishes a clamping direction 91 when the clamping body 65 is fastened to the base 4 using the clamping arrangement fastener 67. Tightening of the clamping arrangement fastener 67 has caused the clamping body 65 to move slightly in the displacement direction 92 guided by the clamping arrangement fastener 67 and the area of slidable contact 69 between the clamping body 65 and the clamping head 61. As described above with relation to figs. 1b and 1d, the vibration sensing element 2 (not shown) is accommodated in a clamping head cavity 68 (not shown) of the clamping head 61 or a cavity of the sensor board support structure 41. The vibration interface 45 has a magnet by which the condition monitoring sensor 1 may be affixed to metallic surfaces of a system to be monitored 93 for transfer of vibrations to the condition monitoring sensor 1.

The clamping arrangement 6 illustrated on fig. 4f has a clamping angle 96 of approximately 75° and a transformation interface angle 97 of approximately 15°. The area of slidable contact 69 is the same as the transformation interface 98, and its oblique surfaces are the body receiving surface 63 (not shown) of the clamping head 61 and the head receiving surface 66 (not shown) of the clamping body 65.

Various alternative embodiments of condition monitoring sensors 1 may be obtained by combining any of the different clamping arrangements 6 with any of the vibration interfaces 45 illustrated on figs. 4a - 4f. The clamping head 61 of any of the clamping arrangements 6 illustrated on figs. 4a - 4f may comprise a clamping head cavity 68 and sensor board pressure elements 64 from any of the clamping head cavities 68 and sensor board pressure elements 64 illustrated on figs. 6b - 6f.

Figs. 5a - 5d illustrate different embodiments of how the condition monitoring sensor 1 may be mounted on a monitored system 93 and communicate with a backend system 94. The monitored system 93 in the form of e.g. a motor or a bearing will generate vibrations during operation. These vibrations are transferred via the vibration interface 45 (not shown) of the condition monitoring sensor 1 and are measured by the vibration sensing element 2 (not shown) as a vibration signal. The vibration signal is transferred to the backend system 94 for e.g. storage, signal processing or real-time monitoring purposes. The backend system 94 can thereby detect errors in the monitored system 93 such as incorrect mounting or failed bearings which cause detectable anomalies in the vibration signal. Actions can then be taken to rectify these errors such as by exchanging a part on the monitored system 93. Figs. 5a - 5d illustrate transfer of information between the backend system 94 and the condition monitoring sensor 1 in both directions via arrows, but communication may also be in only one direction from the condition monitoring sensor 1 to the backend system 94. The backend system may for example be a server or cloud computing running a condition monitoring software, or a smartphone having a vibration visualization app, etc.

Figs. 5a - 5c illustrate the monitored system 93 as a motor, on which a condition monitoring sensor 1 has been mounted.

Fig. 5a illustrates a monitored system 93 depicted as a motor onto which a condition monitoring sensor 1 is mounted in an orientation perpendicular to the motor shaft. The condition monitoring sensor 1 measures the vibrations of the motor as a vibration signal which is transmitted to the backend system 94 via a wired connection. The backend system 94 may also transmit data to the condition monitoring sensor 1 for the purpose of modifying e.g. at which sample rate the vibration signal is measured or other settings related to the operation of the condition monitoring sensor 1.

Fig. 5b illustrates a monitored system 93 identical to that of fig. 5a. The condition monitoring sensor 1 is mounted in an orientation that is axially aligned with the motor shaft. The measured vibration signal is transmitted to the backend system 94 via an established wired or wireless network such as via WiFi. The backend system 94 can still send instructions to the condition monitoring sensor 1 as described above with reference to fig. 5a.

Fig. 5c illustrates a monitored system 93 identical to that of fig. 5a and 5b. Two condition monitoring sensors 1 are mounted on the motor and communicate directly with the backend system 94 via some form of wireless connection such as Bluetooth or LoRaWAN. The use of multiple condition monitoring sensors 1 may provide benefits such as the ability to detect different types of machine errors that might only be detectable at specific locations on the motor. Having multiple sources of the same vibration signal can also be used to improve measurements perturbed by noise.

Fig. 5d illustrates a monitored system 93 in the form of a bearing. The condition monitoring sensor 1 is mounted on the housing of the bearing such that it is near the vibration source. Communication between the condition monitoring sensor 1 and backend system 94 is shown to be via a wired connection.

Figs. 6a - 6f illustrate perspective views of different embodiments of parts of the clamping arrangement 6, in particular the sensor board pressure elements 64 and sensor board clamping surface 62 of the clamping head 61. The mentioned features of the clamping heads 61 illustrated on figs. 6a - 6f may also be thought of as belonging to the sensor board support structure 41 of the base 4. In such an embodiment, the sensor board support structure 41 of the base 4 provides the sensor board pressure elements and sensor board clamping surface which is brought into contact with the first sensor board surface 31. The sensor board support structure 41 additionally provides a cavity which may accommodate the vibration sensing element 2 and other electronic components. The matching clamping head 61 of such an embodiment may advantageously have a substantially flat sensor board clamping surface such as when the second sensor board surface 32 contains no electronic components and is substantially flat.

Fig. 6a shows an embodiment of the clamping arrangement 6 which is functionally similar to that of figs. 1a - le. Figs. 6b - 6f illustrate different embodiments of the clamping head 61 with different types of sensor board pressure elements 64 and sensor board clamping surface 62. These embodiments may be related to figs. 3a - 3d which illustrate different embodiments of the second clamping region 34 to which an approximately corresponding sensor board clamping surface 62 may be identified on figs. 6b - 6f.

Fig. 6a illustrates a perspective view of the clamping arrangement 6 comprising a clamping head 61, clamping body 65 and clamping arrangement fastener 67. The clamping head cavity 68 is formed by the sensor board pressure elements 64 which terminate in the sensor board clamping surface 62 that makes contact with the sensor board 3 (not shown) once the condition monitoring sensor 1 (not shown) is assembled. The clamping arrangement fastener 67 is illustrated as a screw that passes through the clamping body 65. The clamping body 65 is shown as being slightly displaced in the displacement direction 92 (not shown) with respect to the clamping head 61. The displacement is shown to indicate how the clamping arrangement 6 might look in an assembled configuration, where the clamping arrangement fastener 67 has been used to displace and attach the clamping body 65 to the base 4 (not shown).

Fig. 6b illustrates a perspective view of an embodiment of the clamping head 61 which is also illustrated as part of a clamping arrangement 6 on fig. 6a. The sensor board pressure elements 64 form a cuboid-shaped clamping head cavity 68. Upon mounting of the clamping head 61 against the sensor board 3 (not shown), the clamping head cavity 68 forms an enclosed space which accommodates the vibration sensing element 2 (not shown) and possibly other electronic components of the condition monitoring sensor 1 (not shown).

Fig. 6c illustrates a perspective view of an embodiment of a clamping head 61. The clamping head cavity 68 formed by the sensor board pressure elements 64 now has an opening on one side as compared to the clamping head illustrated on fig. 6b. Upon mounting of the clamping head 61 against the sensor board 3 (not shown), the clamping head cavity 68 forms a space with an opening, such that e.g. circuit traces 75 (not shown) on the sensor board 3 can pass through without being clamped by the sensor board pressure elements 64. This eliminates the need for routing circuit traces 75 in deeper layers of the sensor board 3 to avoid them being clamped.

Fig. 6d illustrates a perspective view of an embodiment of a clamping head 61. The clamping head cavity 68 has an opening on one side like the embodiment illustrated on fig. 6c. The clamping head cavity 68 formed by the sensor board pressure elements 64 can now be said to be divided into three areas; an area adjacent to the opening and two smaller subdivisions divided by a part of the sensor board pressure elements 64 that protrudes into the clamping head cavity 68. The subdivisions allow for the mounting of multiple sensors on the sensor board 3 while still maintaining a clamping of the sensor board 3 (not shown) close to the sensor. The sensors may for example be multiple vibration sensing elements 2 (not shown) or sensors measuring other physical quantities such as temperature or sound.

Fig. 6e illustrates a perspective view of an embodiment of a clamping head 61. The sensor board pressure elements 64 comprise two distinct parts as illustrated. The clamping head cavity 68 will thus have two openings at opposite ends when the clamping head 61 is mounted against the sensor board 3 (not shown). Circuit traces 75 (not shown) on the sensor board 3 (not shown) may thus pass through two openings of the clamping head cavity 68 without being clamped by the sensor board pressure elements 64. This can eliminate the need for routing circuit traces 75 into deeper layers of the sensor board 3 to avoid them being clamped.

Fig. 6f illustrates a perspective view of an embodiment of a clamping head 61. The clamping head 61 is shown with a through hole that forms the clamping head cavity 68. Upon mounting of the clamping head 61 against the sensor board 3 (not shown), the clamping head cavity 68 may form an enclosed space depending on the geometry of the clamping body 65 (not shown). The clamping head 61 on fig. 6f uses less material than the embodiment on fig. 6b and may be easier to manufacture due to it being easily cut from e.g. a square hollow bar, e.g. an extruded aluminum profile.

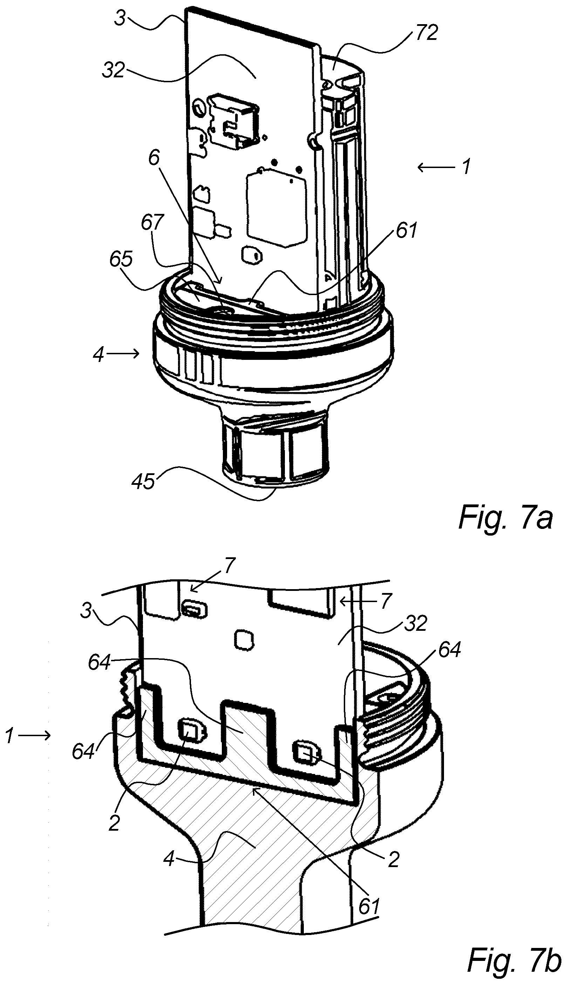

Figs. 7a and 7b illustrate a perspective view of an embodiment of the condition monitoring sensor 1 with a more detailed base 4 as compared to previously described figures such as figs. 1a - 1e.

Fig. 7a illustrates a perspective view of an embodiment of the condition monitoring sensor 1. The embodiment is less simplified than the one illustrated on figs. 1a - 1e and illustrates certain features such as the base 4 and the sensor board 3 in more detail. The base 4 has a circular opening into which the sensor board 3, clamping arrangement 6 and power supply have been placed. The clamping head 61 has been clamped against the second surface 32 of the sensor board 3 via the clamping body 65 which is retained using the clamping arrangement fastener 67. The base 4 has threads by which an enclosure 5 (not shown) may be mounted. The base 4 narrows towards the vibration interface 45 where the condition monitoring sensor 1 may be mounted on a system to be monitored 93 (figs. 5a - 5d).

Fig. 7b illustrates a perspective sectional view of part of an embodiment of the condition monitoring sensor 1. The clamping head 61 has been sectioned to reveal the sensor board pressure elements 64 that apply a force to the second surface 32 of the sensor board 3 at the second clamping region 34 (not shown). The shape of the sensor board pressure elements 64 approximately corresponds to the embodiment seen on fig. 6d. The sensor board pressure elements 64 delimit two areas on the second sensor board surface 32 upon which two vibration sensing elements 2 are mounted. Supplementary electronics 7 are seen mounted in different places on the sensor board 3.

### List of reference signs:

- 1: condition monitoring sensor, such as a vibration sensor
- 2: vibration sensing element
- 3: sensor board
- 4: base
- 5: enclosure
- 6: clamping arrangement
- 7: supplementary electronics
- 31: first sensor board surface
- 32: second sensor board surface
- 34: second clamping region
- 41: sensor board support structure of base
- 42: sensor board receiving surface of sensor board support structure
- 43: clamping body support structure of base
- 44: clamping retaining region of base
- 45: vibration interface
- 61: clamping head
- 62: sensor board clamping surface of the clamping head
- 63: body receiving surface of the clamping head
- 64: sensor board pressure elements of the clamping head
- 65: clamping body
- 66: head receiving surface of the clamping body
- 67: clamping arrangement fastener
- 68: clamping head cavity
- 69: area of slidable contact
- 71: supplementary board
- 72: power supply
- 73: controller
- 74: communication module
- 75: circuit trace
- 76: power supply wire
- 77: board-to-board connector
- 78: radio-frequency transceiver
- 79: antenna
- 91: clamping direction
- 92: displacement direction
- 93: monitored system
- 94: backend system
- 95: second clamping region boundary line
- 96: clamping angle
- 97: transformation interface angle
- 98: transformation interface

## Claims

1. Condition monitoring sensor (1) comprising:
a vibration sensing element (2) mounted on a sensor board (3) comprising a first sensor board surface (31) and a second sensor board surface (32);
a base (4) comprising a sensor board support structure (41) having a sensor board receiving surface (42) conforming to a first clamping region of said first sensor board surface (31);
a clamping arrangement (6) comprising a clamping head (61) and a clamping body (65); said clamping head (61) having a sensor board clamping surface (62) conforming to a second clamping region (34) of said second sensor board surface (32) and a body receiving surface (63), and said clamping body (65) having a head receiving surface (66);
said clamping arrangement (6) being arranged to establish a clamping direction (91) to clamp said sensor board (3) between said clamping head (61) and said sensor board support structure (41) of said base (4) by means of said clamping head (61) and said clamping body (65); and
wherein said head receiving surface (66) is slidably in contact (69) with said body receiving surface (63);
**characterized in that** said clamping arrangement (6) is arranged to establish said clamping direction (91) when said clamping body (65) or said clamping head (61) is moved relative to said base (4) along a displacement direction (92) different from said clamping direction (91) and said head receiving surface (66) and said body receiving surface (63) slide on each other.

2. The condition monitoring sensor (1) of claim 1, wherein a dimension of a cross section of said clamping head (61) and/or said clamping body (65) varies along said displacement direction (92); such as wherein said clamping head (61) and/or said clamping body (65) tapers along or against said displacement direction (92); or such as wherein said clamping head (61) and/or said clamping body (65) is wedge shaped.

3. The condition monitoring sensor (1) of any one of the preceding claims, wherein a transformation interface angle (97) of said clamping arrangement (6), defined as an angle between said displacement direction (92) and at least one oblique surface or transformation interface (98) of said clamping arrangement (6), is in the range of 5° - 80°, for example 10° - 50°, 10° - 45°, 10° - 30°, 15° - 30°, 15° - 25°, or, preferably, 15° -20° or 20° - 30° or 20° - 25°.

4. The condition monitoring sensor (1) of claim 3, wherein said at least one transformation interface (98) is an area of contact between one or more of: said clamping head (61) and said clamping body (65); said clamping head (61) and said sensor board (3); said clamping body (65) and said clamping body support structure (43).

5. The condition monitoring sensor (1) of claim 3, wherein said at least one oblique surface is one or more surface of: said sensor board clamping surface (62); said body receiving surface (63); said head receiving surface (66); said second sensor board surface (32); a surface of said clamping body (65) in contact with said clamping body support structure (43).

6. The condition monitoring sensor (1) of any one of the preceding claims, wherein said sensor board clamping surface (62) is formed by one or more sensor board pressure elements (64) defining at least one clamping head cavity (68) for accommodating said vibration sensing element (2) and being arranged to distribute a clamping force in the clamping direction (91) over an area of the sensor board (2).

7. The condition monitoring sensor (1) of any one of the preceding claims, wherein said clamping arrangement (6) comprises a clamping arrangement fastener (67) for fastening said clamping body (65) or said clamping head (61) relative to said base (4); for example wherein said clamping arrangement fastener (67) is a fastener extending through said clamping body (65) or said clamping head (61), such as a screw or bolt, along said displacement direction (92); or for example wherein said clamping arrangement fastener (67) is a spring clip, spring or push rod, arranged to assert a force against said clamping body (65) or clamping head (61) along said displacement direction (92).

8. The condition monitoring sensor (1) of any one of the preceding claims, wherein said clamping body (65) is a part of said base (4); or wherein said base (4) comprises a clamping body support structure (43).

9. The condition monitoring sensor (1) of any one of the preceding claims, wherein said displacement direction (92) is different from said clamping direction (91) by a clamping angle (96) of at least 30°, such as in the range of 30° - 150°, for example 45° - 135°, 60° - 120°, 75° - 105°, 80° - 100°, or approximately perpendicular, i.e. 90°.

10. The condition monitoring sensor (1) of any one of the preceding claims, wherein said base (4) comprises a vibration interface (45) for receiving vibrations; optionally wherein said vibration interface (45) comprises threads for mounting; a flat surface suitable for magnetic or adhesive mounting; and/or a pointed rod suitable for manual probing.

11. The condition monitoring sensor (1) of any one of the preceding claims, wherein said vibration sensing element (2) comprises a micro-electromechanical system MEMS and/or wherein said sensor board (3) is a printed circuit board PCB.

12. The condition monitoring sensor (1) of any one of the preceding claims, wherein said condition monitoring sensor (1) comprises an enclosure (5) suitable for enclosing said vibration sensing element (2), sensor board (3), base (4), clamping arrangement (6) and possibly supplementary electronics (7) and a power supply (72) suitable for providing power to its electronics; and optionally wherein said condition monitoring sensor (1) is a wireless sensor.

13. Method of fastening a sensor board (3) in a condition monitoring sensor (1), the method comprising steps of:
providing a sensor board (3) comprising a first sensor board surface (31) with a first clamping region and a second sensor board surface (32) with a second clamping region (34), and said sensor board (3) having a vibration sensing element (2) mounted thereon;
providing a base (4) comprising a sensor board support structure (41) having a sensor board receiving surface (42) conforming to said first clamping region;
providing a clamping arrangement (6) comprising a clamping head (61) and a clamping body (65); said clamping head (61) having a sensor board clamping surface (62) conforming to said second clamping region (34) and a body receiving surface (63), and said clamping body (65) having a head receiving surface (66);
establishing a clamping direction (91) to clamp said sensor board (3) between said clamping head (61) and said sensor board support structure (41) by sequentially or partly simultaneously performing the following steps:
placing said sensor board (3) with said first clamping region against said sensor board receiving surface (42);
placing said clamping head (61) with said sensor board clamping surface (62) against said second clamping region (34);
placing said clamping body (65) with said head receiving surface (66) slidably in contact with said body receiving surface (63);
establishing said clamping direction (91) by moving said clamping body (65) or said clamping head (61) relative to said base (4);
**characterized in that** said moving said clamping body (65) or said clamping head (61) relative to said base (4) is along a displacement direction (92) different from said clamping direction (91), whereby said head receiving surface (66) and said body receiving surface (63) slide on each other.

14. The method of fastening a sensor board (3) according to claim 13, wherein said condition monitoring sensor (1) is the condition monitoring sensor according to any one of the claims 1 - 12.

15. Method of removing the sensor board (3) from the condition monitoring sensor (1) of any one of the claims 1 - 12, the method comprising steps of:
moving said clamping body (65) or said clamping head (61) relative to said base (4) along the opposite of the displacement direction (92), thereby releasing the clamping direction (91); and
removing said sensor board (3) from said sensor board receiving surface (42).

## Patentansprüche

1. Zustandsüberwachungssensor (1), umfassend:
ein Schwingungserfassungselement (2), das auf einer Sensorplatine (3), umfassend eine erste Sensorplatinenoberfläche (31) und eine zweite Sensorplatinenoberfläche (32), montiert ist;
eine Basis (4), umfassend eine Sensorplatinenträgerstruktur (41), die eine Sensorplatinenaufnahmeoberfläche (42), die zu einer ersten Klemmregion der ersten Sensorplatinenoberfläche (31) passt, aufweist;
eine Klemmanordnung (6), umfassend einen Klemmkopf (61) und einen Klemmkörper (65); wobei der Klemmkopf (61) eine Sensorplatinenklemmoberfläche (62), die zu einer zweiten Klemmregion (34) der zweiten Sensorplatinenklemmoberfläche (32) passt, und eine Körperaufnahmeoberfläche (63) aufweist, und wobei der Klemmkörper (65) eine Kopfaufnahmeoberfläche (66) aufweist;
wobei die Klemmanordnung (6) angeordnet ist, um eine Klemmrichtung (91) zu etablieren, um die Sensorplatine (3) zwischen dem Klemmkopf (61) und der Sensorplatinenträgerstruktur (41) der Basis (4) mittels des Klemmkopfs (61) und des Klemmkörpers (65) zu klemmen; und
wobei die Kopfaufnahmeoberfläche (66) mit der Körperaufnahmeoberfläche (63) gleitbar in Kontakt (69) steht;
**dadurch gekennzeichnet, dass** die Klemmanordnung (6) angeordnet ist, um die Klemmrichtung (91) zu etablieren, wenn der Klemmkörper (65) oder der Klemmkopf (61) relativ zu der Basis (4) entlang einer Verschiebungsrichtung (92), die sich von der Klemmrichtung (91) unterscheidet, bewegt wird und die Kopfaufnahmeoberfläche (66) und die Körperaufnahmeoberfläche (63) aufeinander gleiten.

2. Zustandsüberwachungssensor (1) nach Anspruch 1, wobei eine Abmessung eines Querschnitts des Klemmkopfs (61) und/oder des Klemmkörpers (65) entlang der Verschiebungsrichtung (92) variiert; wie wobei sich der Klemmkopf (61) und/oder der Klemmkörper (65) entlang oder gegen die Verschiebungsrichtung (92) verjüngt; oder wie wobei der Klemmkopf (61) und/oder der Klemmkörper (65) keilförmig ist.

3. Zustandsüberwachungssensor (1) nach einem der vorstehenden Ansprüche, wobei ein Transformationsschnittstellenwinkel (97) der Klemmanordnung (6), der als ein Winkel zwischen der Verschiebungsrichtung (92) und mindestens einer schrägen Oberfläche oder einer Transformationsschnittstelle (98) der Klemmanordnung (6) definiert ist, in dem Bereich von 5° - 80°, zum Beispiel 10° - 50°, 10° - 45°, 10° - 30°, 15° - 30°, 15° - 25°, oder, vorzugsweise, 15° - 20° oder 20° - 30° oder 20° - 25°, liegt.

4. Zustandsüberwachungssensor (1) nach Anspruch 3, wobei die mindestens eine Transformationsschnittstelle (98) ein Kontaktbereich zwischen einem oder mehreren ist von: dem Klemmkopf (61) und dem Klemmkörper (65); dem Klemmkopf (61) und der Sensorplatine (3); dem Klemmkörper (65) und der Klemmkörperträgerstruktur (43).

5. Zustandsüberwachungssensor (1) nach Anspruch 3, wobei die mindestens eine schräge Oberfläche eine oder mehrere Oberflächen ist von: der Sensorplatinenklemmoberfläche (62); der Körperaufnahmeoberfläche (63); der Kopfaufnahmeoberfläche (66); der zweiten Sensorplatinenoberfläche (32); einer Oberfläche des Klemmkörpers (65) in Kontakt mit der Klemmkörperträgerstruktur (43).

6. Zustandsüberwachungssensor (1) nach einem der vorstehenden Ansprüche, wobei die Sensorplatinenklemmoberfläche (62) durch ein oder mehrere Sensorplatinendruckelemente (64) ausgebildet wird, die mindestens einen Klemmkopfhohlraum (68) zum Unterbringen des Schwingungserfassungselements (2) definieren und angeordnet sind, um eine Klemmkraft in der Klemmrichtung (91) über einen Bereich der Sensorplatine (2) zu verteilen.

7. Zustandsüberwachungssensor (1) nach einem der vorstehenden Ansprüche, wobei die Klemmanordnung (6) ein Klemmanordnungsbefestigungsmittel (67) zum Befestigen des Klemmkörpers (65) oder des Klemmkopfs (61) relativ zu der Basis (4) umfasst; zum Beispiel wobei das Klemmanordnungsbefestigungsmittel (67) ein Befestigungsmittel, wie eine Schraube oder ein Bolzen, ist, das sich durch den Klemmkörper (65) oder den Klemmkopf (61) entlang der Verschiebungsrichtung (92) erstreckt; oder zum Beispiel wobei das Klemmanordnungsbefestigungsmittel (67) eine Federklemme, eine Feder oder eine Schubstange ist, die angeordnet ist, um eine Kraft gegen den Klemmkörper (65) oder den Klemmkopf (61) entlang der Verschiebungsrichtung (92) auszuüben.

8. Zustandsüberwachungssensor (1) nach einem der vorstehenden Ansprüche, wobei der Klemmkörper (65) ein Teil der Basis (4) ist; oder wobei die Basis (4) eine Klemmkörperträgerstruktur (43) umfasst.

9. Zustandsüberwachungssensor (1) nach einem der vorstehenden Ansprüche, wobei sich die Verschiebungsrichtung (92) von der Klemmrichtung (91) um einen Klemmwinkel (96) von mindestens 30°, wie in dem Bereich von 30° - 150°, zum Beispiel 45° - 135°, 60° - 120°, 75° - 105°, 80° - 100°, oder etwa senkrecht, d.h. 90°, unterscheidet.

10. Zustandsüberwachungssensor (1) nach einem der vorstehenden Ansprüche, wobei die Basis (4) eine Schwingungsschnittstelle (45) zum Aufnehmen von Schwingungen umfasst; optional wobei die Schwingungsschnittstelle (45) Gewinde zum Montieren umfasst; eine flache Oberfläche, geeignet für eine magnetische oder adhäsive Montage; und/oder eine spitze Stange, geeignet für manuelles Sondieren.

11. Zustandsüberwachungssensor (1) nach einem der vorstehenden Ansprüche, wobei das Schwingungserfassungselement (2) ein mikroelektromechanisches System, MEMS, umfasst, und/oder wobei die Sensorplatine (3) eine Leiterplatte, LP, ist.

12. Zustandsüberwachungssensor (1) nach einem der vorstehenden Ansprüche, wobei der Zustandsüberwachungssensor (1) ein Gehäuse (5), das zum Einhausen des Schwingungserfassungselements (2), der Sensorplatine (3), der Basis (4), der Klemmanordnung (6) und möglicherweise zusätzlicher Elektronik (7) geeignet ist, und eine Stromversorgung (72), die zum Bereitstellen von Strom an seine Elektronik geeignet ist, umfasst; und optional wobei der Zustandsüberwachungssensor (1) ein drahtloser Sensor ist.

13. Verfahren zum Befestigen einer Sensorplatine (3) in einem Zustandsüberwachungssensor (1), das Verfahren umfassend die Schritte
Bereitstellen einer Sensorplatine (3), umfassend eine erste Sensorplatinenoberfläche (31) mit einer ersten Klemmregion und eine zweite Sensorplatinenoberfläche (32) mit einer zweiten Klemmregion (34), und wobei die Sensorplatine (3) ein Schwingungserfassungselement (2), das darauf montiert ist, aufweist;
Bereitstellen einer Basis (4), umfassend eine Sensorplatinenträgerstruktur (41), die eine Sensorplatinenaufnahmeoberfläche (42), die zu der ersten Klemmregion passt, aufweist;
Bereitstellen einer Klemmanordnung (6), umfassend einen Klemmkopf (61) und einen Klemmkörper (65); wobei der Klemmkopf (61) eine Sensorplatinenklemmoberfläche (62), die zu der zweiten Klemmregion (34) passt, und eine Körperaufnahmeoberfläche (63) aufweist, und wobei der Klemmkörper (65) eine Kopfaufnahmeoberfläche (66) aufweist;
Etablieren einer Klemmrichtung (91), um die Sensorplatine (3) zwischen dem Klemmkopf (61) und der Sensorplatinenträgerstruktur (41) zu klemmen durch sequenzielles oder teilweise gleichzeitiges Durchführen der folgenden Schritte:
Platzieren der Sensorplatine (3) mit der ersten Klemmregion gegen die Sensorplatinenaufnahmeoberfläche (42);
Platzieren des Klemmkopfs (61) mit der Sensorplatinenklemmoberfläche (62) gegen die zweite Klemmregion (34);
Platzieren des Klemmkörpers (65) mit der Kopfaufnahmeoberfläche (66) gleitbar in Kontakt mit der Körperaufnahmeoberfläche (63);
Etablieren der Klemmrichtung (91) durch Bewegen des Klemmkörpers (65) oder des Klemmkopfs (61) relativ zu der Basis (4);
**dadurch gekennzeichnet, dass** das Bewegen des Klemmkörpers (65) oder des Klemmkopfs (61) relativ zu der Basis (4) entlang einer Verschiebungsrichtung (92), die sich von der Klemmrichtung (91) unterscheidet, erfolgt, wodurch die Kopfaufnahmeoberfläche (66) und die Körperaufnahmeoberfläche (63) aufeinander gleiten.

14. Verfahren zum Befestigen einer Sensorplatine (3) nach Anspruch 13, wobei der Zustandsüberwachungssensor (1) der Zustandsüberwachungssensor nach einem der Ansprüche 1 bis 12 ist.

15. Verfahren zum Entfernen der Sensorplatine (3) von dem Zustandsüberwachungssensor (1) nach einem der Ansprüche 1 bis 12, das Verfahren umfassend die Schritte:
Bewegen des Klemmkörpers (65) oder des Klemmkopfs (61) relativ zu der Basis (4) entlang der Gegenrichtung der Verschiebungsrichtung (92), wobei dadurch die Klemmrichtung (91) gelöst wird; und
Entfernen der Sensorplatine (3) von der Sensorplatinenaufnahmeoberfläche (42).

## Revendications

1. Capteur de surveillance d'état (1) comprenant :
un élément de détection de vibration (2) monté sur une carte de capteur (3) comprenant une première surface de carte de capteur (31) et une seconde surface de carte de capteur (32) ;
une base (4) comprenant une structure de support de carte de capteur (41) ayant une surface de réception de carte de capteur (42) se conformant à une première région de serrage de ladite première surface de carte de capteur (31) ;
un agencement de serrage (6) comprenant une tête de serrage (61) et un corps de serrage (65) ; ladite tête de serrage (61) ayant une surface de serrage de carte de capteur (62) se conformant à une seconde région de serrage (34) de ladite seconde surface de carte de capteur (32) et une surface de réception de corps (63), et ledit corps de serrage (65) ayant une surface de réception de tête (66) ;
ledit agencement de serrage (6) étant agencé pour établir une direction de serrage (91) afin de serrer ladite carte de capteur (3) entre ladite tête de serrage (61) et ladite structure de support de carte de capteur (41) de ladite base (4) au moyen de ladite tête de serrage (61) et dudit corps de serrage (65) ; et
dans lequel ladite surface de réception de tête (66) est en contact coulissant (69) avec ladite surface de réception de corps (63) ;
**caractérisé en ce que** ledit agencement de serrage (6) est agencé pour établir ladite direction de serrage (91) lorsque ledit corps de serrage (65) ou ladite tête de serrage (61) est déplacé par rapport à ladite base (4) le long d'une direction de déplacement (92) différent de ladite direction de serrage (91) et ladite surface de réception de tête (66) et ladite surface de réception de corps (63) glissent l'une sur l'autre.

2. Capteur de surveillance d'état (1) selon la revendication 1, dans lequel une dimension d'une section transversale de ladite tête de serrage (61) et/ou dudit corps de serrage (65) varie le long de ladite direction de déplacement (92) ; tel que dans lequel ladite tête de serrage (61) et/ou ledit corps de serrage (65) s'effilent le long ou contre ladite direction de déplacement (92) ; ou tel que dans lequel ladite tête de serrage (61) et/ou ledit corps de serrage (65) sont cunéiformes.

3. Capteur de surveillance d'état (1) selon l'une quelconque des revendications précédentes, dans lequel un angle d'interface de transformation (97) dudit agencement de serrage (6), défini comme un angle entre ledite direction de déplacement (92) et au moins une surface oblique ou interface de transformation (98) dudit agencement de serrage (6), est compris dans la plage de 5° à 80°, par exemple de 10° à 50°, de 10° à 45°, de 10° à 30°, de 15° à 30°, de 15° à 25°, ou, de préférence, de 15° à 20° ou de 20° à 30° ou de 20° à 25°.

4. Capteur de surveillance d'état (1) selon la revendication 3, dans lequel ladite au moins une interface de transformation (98) est une zone de contact entre une ou plusieurs parmi : ladite tête de serrage (61) et ledit corps de serrage (65) ; ladite tête de serrage (61) et ladite carte de capteur (3) ; ledit corps de serrage (65) et ladite structure de support de corps de serrage (43).

5. Capteur de surveillance d'état (1) selon la revendication 3, dans lequel ladite au moins une surface oblique est une ou plusieurs surfaces parmi : ladite surface de serrage de carte de capteur (62) ; ladite surface de réception de corps (63) ; ladite surface de réception de tête (66) ; ladite seconde surface de carte de capteur (32) ; une surface dudit corps de serrage (65) en contact avec ladite structure de support de corps de serrage (43).

6. Capteur de surveillance d'état (1) selon l'une quelconque des revendications précédentes, dans lequel ladite surface de serrage de carte de capteur (62) est formée par un ou plusieurs éléments de pression de carte de capteur (64) définissant au moins une cavité de tête de serrage (68) permettant d'accueillir ledit élément de détection de vibration (2) et étant agencés pour répartir une force de serrage dans la direction de serrage (91) sur une zone de la carte de capteur (2).

7. Capteur de surveillance d'état (1) selon l'une quelconque des revendications précédentes, dans lequel ledit agencement de serrage (6) comprend un élément de fixation d'agencement de serrage (67) permettant de fixer ledit corps de serrage (65) ou ladite tête de serrage (61) par rapport à ladite base (4) ; par exemple dans lequel ledit élément de fixation d'agencement de serrage (67) est un élément de fixation s'étendant à travers ledit corps de serrage (65) ou ladite tête de serrage (61), telle qu'une vis ou un boulon, le long de ladite direction de déplacement (92) ; ou par exemple dans lequel ledit élément de fixation d'agencement de serrage (67) est une pince à ressort, un ressort ou une tige de poussée, agencé pour exercer une force contre ledit corps de serrage (65) ou ladite tête de serrage (61) le long de ladite direction de déplacement (92).

8. Capteur de surveillance d'état (1) selon l'une quelconque des revendications précédentes, dans lequel ledit corps de serrage (65) fait partie de ladite base (4) ; ou dans lequel ladite base (4) comprend une structure de support de corps de serrage (43).

9. Capteur de surveillance d'état (1) selon l'une quelconque des revendications précédentes, dans lequel ladite direction de déplacement (92) est différente de ladite direction de serrage (91) d'un angle de serrage (96) d'au moins 30°, tel que dans la plage de 30° à 150°, par exemple de 45° à 135°, de 60° à 120°, de 75° à 105°, de 80° à 100°, ou approximativement perpendiculaire, c'est-à-dire 90°.

10. Capteur de surveillance d'état (1) selon l'une quelconque des revendications précédentes, dans lequel ladite base (4) comprend une interface de vibration (45) permettant de recevoir des vibrations ; éventuellement dans lequel ladite interface de vibration (45) comprend des filetages destinés au montage ; une surface plane adaptée à un montage magnétique ou adhésif ; et/ou une tige pointue adaptée à un palpage manuel.

11. Capteur de surveillance d'état (1) selon l'une quelconque des revendications précédentes, dans lequel ledit élément de détection de vibration (2) comprend un microsystème électromécanique MEMS et/ou dans lequel ladite carte de capteur (3) est une carte de circuit imprimé PCB.

12. Capteur de surveillance d'état (1) selon l'une quelconque des revendications précédentes, dans lequel ledit capteur de surveillance d'état (1) comprend une enceinte (5) adaptée pour enfermer ledit élément de détection de vibration (2), la carte de capteur (3), la base (4), l'agencement de serrage (6) et éventuellement des composants électroniques supplémentaires (7) et une alimentation électrique (72) adaptée pour fournir de l'énergie à ses composants électroniques ; et éventuellement dans lequel ledit capteur de surveillance d'état (1) est un capteur sans fil.

13. Procédé de fixation d'une carte de capteur (3) dans un capteur de surveillance d'état (1), le procédé comprenant les étapes consistant à :
fournir une carte de capteur (3) comprenant une première surface de carte de capteur (31) avec une première région de serrage et une seconde surface de carte de capteur (32) avec une seconde région de serrage (34), et ladite carte de capteur (3) ayant un élément de détection de vibration (2) monté sur celle-ci ;
fournir une base (4) comprenant une structure de support de carte de capteur (41) ayant une surface de réception de carte de capteur (42) se conformant à ladite première région de serrage ;
fournir un agencement de serrage (6) comprenant une tête de serrage (61) et un corps de serrage (65) ; ladite tête de serrage (61) ayant une surface de serrage de carte de capteur (62) se conformant à ladite seconde région de serrage (34) et une surface de réception de corps (63), et ledit corps de serrage (65) ayant une surface de réception de tête (66) ;
établir une direction de serrage (91) afin de serrer ladite carte de capteur (3) entre ladite tête de serrage (61) et ladite structure de support de carte de capteur (41) en effectuant séquentiellement ou partiellement simultanément les étapes suivantes :
placer ladite carte de capteur (3) avec ladite première région de serrage contre ladite surface de réception de carte de capteur (42) ;
placer ladite tête de serrage (61) avec ladite surface de serrage de carte de capteur (62) contre ladite seconde région de serrage (34) ;
placer ledit corps de serrage (65) avec ladite surface de réception de tête (66) en contact coulissant avec ladite surface de réception de corps (63) ;
établir ladite direction de serrage (91) en déplaçant ledit corps de serrage (65) ou ladite tête de serrage (61) par rapport à ladite base (4) ;
**caractérisé en ce que** ledit déplacement dudit corps de serrage (65) ou de ladite tête de serrage (61) par rapport à ladite base (4) se fait le long d'une direction de déplacement (92) différent de ladite direction de serrage (91), moyennant quoi ladite surface de réception de tête (66) et ladite surface de réception de corps (63) glissent l'une sur l'autre.

14. Procédé de fixation d'une carte de capteur (3) selon la revendication 13, dans lequel ledit capteur de surveillance d'état (1) est le capteur de surveillance d'état selon l'une quelconque des revendications 1 à 12.

15. Procédé de retrait de la carte de capteur (3) du capteur de surveillance d'état (1) selon l'une quelconque des revendications 1 à 12, le procédé comprenant les étapes consistant à :
déplacer ledit corps de serrage (65) ou ladite tête de serrage (61) par rapport à ladite base (4) le long de l'opposé de la direction de déplacement (92), libérant de ce fait la direction de serrage (91) ; et
retirer ladite carte de capteur (3) de ladite surface de réception de carte de capteur (42).
